(19) Europäisches Patentamt
European Patent Office
Office européen des brevets

(11) **EP 3 929 634 B1**

(12) **FASCICULE DE BREVET EUROPEEN**

(45) Date de publication et mention de la délivrance du brevet:
**22.03.2023 Bulletin 2023/12**

(21) Numéro de dépôt: **21177529.1**

(22) Date de dépôt: **03.06.2021**

(51) Classification Internationale des Brevets (IPC):
**G02B 5/20** (2006.01)    **H01L 25/075** (2006.01)
**H01L 33/50** (2010.01)    **H01L 33/60** (2010.01)

(52) Classification Coopérative des Brevets (CPC):
**H01L 33/507; G02B 5/0252; G02B 5/201; G02B 5/285; H01L 25/0753; H01L 33/60;** H01L 33/504; H01L 2933/0041; H01L 2933/0083

(54) **DISPOSITIF D'EMISSION DE LUMIERE, PIXEL COMPORTANT PLUSIEURS TELS DISPOSITIFS, MATRICE DE PIXELS ET PROCEDES DE FABRICATION ASSOCIES**

**LICHTEMITTIERENDE VORRICHTUNG, PIXEL MIT EINER VIELZAHL SOLCHER VORRICHTUNGEN, PIXELMATRIX UND ENTSPRECHENDE HERSTELLUNGSVERFAHREN**

**LIGHT-EMITTING DEVICE, PIXEL COMPRISING A PLURALITY OF SUCH DEVICES, PIXEL MATRIX AND ASSOCIATED MANUFACTURING METHODS**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.06.2020 FR 2006161**

(43) Date de publication de la demande:
**29.12.2021 Bulletin 2021/52**

(73) Titulaire: **Commissariat à l'Energie Atomique et aux Energies Alternatives 75015 Paris (FR)**

(72) Inventeurs:
• **BEN BAKIR, Badhise 38054 GRENOBLE CEDEX 9 (FR)**
• **GASSE, Adrien 38054 GRENOBLE CEDEX 9 (FR)**
• **LE BLEVENNEC, Gilles 38054 GRENOBLE CEDEX 9 (FR)**
• **OLIVIER, Nicolas 38054 GRENOBLE CEDEX 9 (FR)**

(74) Mandataire: **Cabinet Camus Lebkiri 25 rue de Maubeuge 75009 Paris (FR)**

(56) Documents cités:
**EP-A1- 2 423 736      EP-A1- 3 024 030 WO-A1-2018/084919      FR-A1- 3 061 605**

• **JOAO M M SANTOS ET AL: "Hybrid GaN LED with capillary-bonded II-VI MQW color-converting membrane for visible light communicat", SEMICONDUCTOR SCIENCE AND TECHNOLOGY, IOP PUBLISHING LTD, GB, vol. 30, no. 3, 27 janvier 2015 (2015-01-27), page 35012, XP020281496, ISSN: 0268-1242, DOI: 10.1088/0268-1242/30/3/035012 [extrait le 2015-01-27]**

**Description**

**DOMAINE TECHNIQUE DE L'INVENTION**

La présente invention est relative à un dispositif optoélectronique d'émission de lumière, à un pixel comportant une pluralité de dispositifs optoélectroniques d'émission de lumière, à un afficheur comprenant une matrice de tels pixels, et à leurs procédés de fabrication.

**ARRIERE-PLAN TECHNOLOGIQUE DE L'INVENTION**

D'une manière générale, un paramètre important pour les dispositifs d'affichage est d'avoir le « gamut » le plus grand possible. En synthèse des couleurs, qu'elle soit additive ou soustractive, le gamut ou gamme de couleurs est la partie de l'ensemble des couleurs qu'un certain type de matériel permet de reproduire. Par ailleurs, les dispositifs d'éclairage et d'affichage évoluent continuellement en augmentant les flux lumineux et la définition (c'est-à-dire la résolution) des surfaces émissives. Pour les écrans par exemple, cela se traduit par le passage des tubes cathodiques aux écrans à cristaux liquides et désormais aux écrans OLED (de l'anglais « Organic Light-Emitting Diode »). Pour l'éclairage, il s'agit par exemple du passage de l'ampoule à incandescence à la LED (de l'anglais « Light-Emitting Diode »).

L'utilisation d'une matrice de LEDs à des fins d'affichage ou d'éclairage (par exemple pour les phares, dans l'industrie automobile) requiert d'adapter la technologie des LEDs à semiconducteurs, par exemple en nitrure de gallium GaN, à une émission matricielle pixellisée. La technologie des semiconducteurs permet en effet la fabrication de matrices avec des pixels allant d'un micromètre à quelques dizaines de micromètres. Mais les LEDs au nitrure de gallium GaN émettent principalement de la lumière bleue, dans une gamme de longueurs d'onde situées autour de 460 nm.

Pour obtenir d'autres couleurs, il faut réaliser une opération de conversion de lumière à l'échelle du pixel. Comme la lumière bleue est la plus énergétique du spectre visible, elle peut être convertie par photoluminescence en une lumière verte ou rouge moins énergétique. La photoluminescence est un processus par lequel une substance s'excite en absorbant des photons, puis se désexcite en réémettant des photons de plus faible énergie. La photoluminescence recouvre deux formes : fluorescence et phosphorescence. La fluorescence est une photoluminescence rapide tandis que la phosphorescence est une photoluminescence lente : c'est la fluorescence qui convient aux applications d'affichage et d'éclairage.

La fluorescence peut être obtenue au moyen de fluorophores, se présentant par exemple sous forme de poudres associées à une matrice polymère.

Pour pouvoir être confinés dans des pixels de quelques microns, ces fluorophores doivent être de dimensions submicroniques. Les matériaux actuellement disponibles sont des boîtes quantiques 3D (« quantum dots » en anglais) de semi-conducteurs tels que le séléniure de cadmium CdSe, le phosphure d'indium InP ou le sulfure d'argent et d'indium AgInS2, ou des nanophosphores d'oxyde, tel que du YAG:Ce (grenat d'yttrium et d'aluminium dopé au cérium), de sulfure ou de fluorure.

Par ailleurs, une contrainte de la photo-conversion appliquée à des micro-pixels est l'épaisseur supplémentaire qu'elle requiert, qui pour des raisons techniques, de facteur de forme notamment, doit rester de l'ordre de la taille des pixels : pour des pixels de 3 $\mu$m par exemple, l'épaisseur de conversion doit rester de l'ordre de 3 $\mu$m maximum ; ou de 10 $\mu$m maximum pour des pixels de 10 $\mu$m. Indépendamment de la taille des pixels, le tableau 1 ci-dessous montre l'épaisseur de conversion requise pour absorber la lumière bleue à 460 nm, respectivement pour une boîte quantique 3D de phosphure d'indium InP ou de séléniure de cadmium CdSe ou pour un nanophosphore LuAG:Ce (grenat d'aluminium de Lutetium dopé au cérium), et pour différents taux de charge volumique en fluorophore dans le composite. Le tableau 2 ci-dessous montre quant à lui le pourcentage d'absorption atteint pour les différents fluorophores et taux de charge du tableau 1.

| Tableau 1<br>Taux de charge volumique (%) | InP | CdSe | LuAG:Ce |
|---|---|---|---|
| 10 | 8 $\mu$m | 5 $\mu$m | 150 $\mu$m |
| 20 | 3 $\mu$m | 2.5 $\mu$m | 90 $\mu$m |
| 30 | 1.2 $\mu$m | 1.2 $\mu$m | 50 $\mu$m |

| Tableau 2<br>Taux de charge volumique (%) | InP | CdSe | LuAG:Ce |
|---|---|---|---|
| 10 | 96 | 94 | 94 |
| 20 | 98 | 96 | 95 |
| 30 | 99 | 97 | 95 |

D'une manière générale, les nanophosphores comme le LuAG:Ce requièrent une épaisseur de conversion de plusieurs dizaines de microns pour absorber le bleu en totalité ou quasi-totalité, ce qui n'est pas compatible avec des tailles de pixels inférieures à 10 $\mu$m.

Les boites quantiques 3D paraissent donc plus prometteuses que les nanosphores, puisque l'épaisseur requise pour une conversion efficace est nettement plus petite que dans le cas de nanosphores.

L'article « Monolithic red/green/blue micro-LEDs with HBR and DBR structures », de Guan-Syun Chen et al., IEEE Photonics Technology Letters, Vol. 30, No. 3, 1er février 2018, décrit d'ailleurs un pixel comportant trois diodes électroluminescentes au nitrure de gallium : une première sans couche de conversion pour l'émission de lumière bleue, une deuxième avec couche de conversion pour l'émission de lumière rouge et une troisième avec couche de conversion pour l'émission de lumière verte. Les fluorophores utilisés sont des boîtes quantiques 3D. Les trois diodes sont séparées les unes des autres au niveau de leur couche active, et au niveau de leur couche de conversion le cas échéant, par une couche absorbant le rayonnement lumineux, afin de limiter la diaphonie (« crosstalk » en anglais) pour améliorer la pureté et le contraste des couleurs. Un miroir de Bragg inférieur, agencé sous le substrat, est configuré pour réfléchir les trois couleurs. Un miroir de Bragg supérieur est agencé sur les couches de conversion des deuxième et troisième diodes afin de bloquer la lumière bleue.

Les boîtes quantiques 3D, telles que celles employées dans l'article en question souffrent d'un manque de stabilité notable lorsqu'elles sont soumises à un flux de lumière ou de chaleur, ce qui est le cas dans les dispositifs d'affichage ou d'éclairage. Des solutions d'encapsulation existent mais qui ne permettent qu'une faible luminosité et une faible résolution.

Dans ce contexte, il existe donc un besoin d'un dispositif optoélectronique, robuste, capable d'émettre un rayonnement lumineux ayant une couleur différente du bleu de manière stable et avec une bonne efficacité, et cela même si le dispositif est de dimensions microniques. Il existe également un besoin d'un pixel comportant plusieurs tels dispositifs optoélectroniques, émettant des rayonnements ayant des couleurs différentes et saturées, pour permettre un affichage en couleurs.

**RESUME DE L'INVENTION**

Pour résoudre au moins en partie les problèmes mentionnées ci-dessus, on propose un dispositif optoélectronique d'émission de lumière comprenant :

- une diode électroluminescente configurée pour émettre un premier rayonnement, et

- une couche de conversion qui s'étend au-dessus de la diode électroluminescente et qui est configurée pour convertir une partie au moins du premier rayonnement en un deuxième rayonnement, par photoluminescence, la couche de conversion étant délimitée latéralement par une surface latérale, et dans lequel :

- la couche de conversion comprend au moins un puit quantique planaire configuré pour émettre le deuxième rayonnement,

- un réseau de diffraction, configuré pour extraire une partie au moins du deuxième rayonnement de la couche de conversion, le réseau de diffraction étant gravé sur une face supérieure de la couche de conversion, et

- un réflecteur latéral ayant une surface réfléchissante qui s'étend transversalement par rapport à la couche de conversion, en face d'une partie au moins de la surface latérale de la couche de conversion ;

- la surface réfléchissante du réflecteur et la surface latérale de la couche de conversion étant séparées l'une de l'autre par un matériau ayant un indice optique $n_2$, et dans lequel une distance séparant la surface réfléchissante du réflecteur de la surface latérale de la couche de conversion est comprise entre $\lambda/(n_2 \times 40)$ et $\lambda/(n_2 \times 2)$ où $\lambda$, est la longueur d'onde moyenne du deuxième rayonnement.

Convertir le premier rayonnement par photoluminescence grâce à un puit quantique planaire permet de résoudre les problèmes d'épaisseur d'absorption mentionnés plus haut, rencontrés avec des nanophosphores.

En effet, une épaisseur de la couche de conversion comprise typiquement entre 0,1 et 1 micron s'avère en général suffisante pour absorber la majeure partie du premier rayonnement dans la couche de conversion (en semi-conducteur), et permettre ainsi l'émission du deuxième rayonnement, par recombinaison radiative dans le puit quantique. A titre d'exemple, dans le cas où le premier rayonnement a un spectre situé principalement dans le bleu, par exemple dans une gamme de longueurs d'onde comprise entre 430 et 490 nanomètres, et où le deuxième rayonnement a un spectre situé principalement dans le rouge, par exemple dans une gamme de longueurs d'ondes située entre 600 et 700 nanomètres, pour une couche de conversion à puit quantique planaire de type AlInGaP/InGaP (Phosphorure d'Aluminium d'indium et de Galium / Phosphorure d'Indium-Gallium), une épaisseur comprise entre 0,2 et 0,5 micron permet d'absorber la majeure partie du premier rayonnement.

Par ailleurs, les structures à puit quantique planaire ne souffrent pas du manque de stabilité des boites quantiques 3D. De telles structures à puit quantique planaire ont en effet une très bonne résistance au flux et en température car elles sont généralement réalisées par épitaxie à haute température.

En revanche, en l'absence de dispositions particulières, la puissance lumineuse émise finalement par une couche de conversion à puit quantique planaire peut s'avérer relativement faible, une partie importante du deuxième rayonnement restant en quelque sorte piégée dans cette couche, par réflexion totale interne, du fait de la valeur élevée de l'indice optique des matériaux formant cette couche (généralement de l'ordre de 3 ou plus).

Le réseau de diffraction mentionné ci-dessus, qui forme un cristal photonique uni ou bi-dimensionnel, permet à une partie plus importante du deuxième rayonnement de sortir de la couche de conversion, pour se propager ensuite jusqu'à l'extérieur du dispositif. En d'autres termes, ce réseau améliore l'efficacité d'extraction du deuxième rayonnement. Il permet en outre d'imposer une direction de propagation et/ou un profil d'intensité donné et/ou une polarisation donnée au rayonnement issu finalement du dispositif optoélectronique, afin de l'adapter aux applications visées.

Le réflecteur latéral coopère avec le réseau de diffraction pour améliorer encore l'efficacité avec laquelle le deuxième rayonnement est extrait de la couche de conversion. En effet, une partie du deuxième rayonnement, qui se propage dans la couche de conversion parallèlement à sa face supérieure, sous la forme d'un mode de propagation guidé, finit par sortir de la couche de conversion au niveau de la surface latérale qui délimite latéralement cette couche. Mais le réflecteur renvoie alors cette partie du deuxième rayonnement vers la couche de conversion, où elle peut à nouveau se propager, parallèlement à la face supérieure de la couche. Le réflecteur permet donc d'augmenter la longueur sur laquelle ce mode de propagation interagit avec le réseau de diffraction, améliorant ainsi l'efficacité d'extraction du deuxième rayonnement.

D'un point de vue optique, le réflecteur latéral permet ainsi, en quelque sorte, de démultiplier le réseau de diffraction et de lui donner une longueur effective supérieure à sa longueur géométrique réelle. Grâce à ce réflecteur, l'efficacité d'extraction du réseau est la même, ou presque la même que celle d'un réseau de diffraction «effectif» qui aurait une extension latérale plus grande que celle du réseau de diffraction gravé sur la couche de conversion (typiquement au moins deux fois plus grande en prenant en compte un miroir latéral avec une réflectivité dégradée, mais cette diffraction «effective» peu tendre vers l'infini avec un miroir latéral idéal avec une réflectivité proche de 100%).

Cela s'avère particulièrement intéressant lorsque le dispositif d'émission de lumière a des dimensions latérales microniques, par exemple de l'ordre d'une dizaine de microns. En effet, le réseau de diffraction gravé sur la face supérieure de la couche de conversion ne comporte alors qu'un nombre limité de motifs répétés périodiquement, par exemple une dizaine de motifs dans le cas d'un réseau 1D, ce qui conduit à une efficacité d'extraction limitée. En outre, lorsque le dispositif a des dimensions latérales microniques, l'épaisseur des différentes couches du dispositif est également réduite (le dispositif ayant alors aussi une épaisseur micronique), si bien qu'une gravure d'un réseau de profondeur importante n'est généralement pas possible, ou pas souhaitable. Cette profondeur de gravure réduite tend elle aussi à limiter l'efficacité d'extraction.

Des résultats de simulation numérique montrent d'ailleurs que pour un dispositif d'émission dépourvu du réflecteur latéral, un réseau de diffraction de 50 à 80 microns de long, voire plus, est nécessaire pour extraire la majeure partie du deuxième rayonnement.

Et à titre d'exemple, pour un réseau 1D de 6 microns de côté comprenant seulement 7 répétitions du motif du réseau, configuré pour extraire un rayonnement dont la longueur d'onde moyenne est de 640 nanomètres (longueur d'onde dans le vide), ces simulations numériques montrent que l'efficacité d'extraction en champ lointain est seulement de 15% environ, en l'absence du réflecteur latéral. Alors qu'en présence du réflecteur latéral, dans le cas où le réflecteur s'étend tout autour du réseau, ce même réseau (de 6 microns de côté) permet d'obtenir une efficacité d'extraction en champ lointain de 80%.

Par ailleurs, écarter un la couche de conversion de la surface réfléchissante permet avantageusement d'éviter un couplage plasmonique vers le métal du réflecteur, lorsque cette surface réfléchissante est métallique (couplage qui causerait des pertes de puissance).

Le fait que la distance entre la couche de conversion et la surface réfléchissante soit inférieure à $\lambda/(n_2 \times 2)$,

permet par ailleurs, d'un point de vue optique, d'éviter une trop grande discontinuité entre le réseau lui-même et son image par la surface réfléchissante. En d'autres termes, cela permet d'obtenir un réseau optique effectif proche d'un réseau de pas régulier, sans discontinuité entre le réseau réel et sa ou ses différentes réplications par la surface réfléchissante. Cela est intéressant, car l'efficacité d'extraction d'un réseau «effectif» étendu et régulier est meilleure que celle d'un réseau effectif étendu, mais avec des discontinuités entre chaque réplication du réseau initial.

On peut prévoir que la surface réfléchissante du réflecteur s'étende autour de la couche de conversion, sur la majeure partie du pourtour de la couche de conversion, voire sur la totalité du pourtour de la couche de conversion. La surface réfléchissante s'étend alors non seulement en face d'une partie de la surface latérale de la couche de conversion, mais tout autour de cette surface latérale, ou quasiment tout autour de celle-ci. Le pourtour de la couche de conversion désigne une ligne qui entoure cette couche de conversion latéralement, en la bordant. En d'autres termes, il s'agit du périmètre de cette couche. Le fait que la surface réfléchissante du réflecteur s'étende autour de la couche de conversion sur la majeure partie du pourtour de cette couche signifie que la surface réfléchissante du réflecteur s'étend en vis-à-vis d'une ou plusieurs parties de la surface latérale de la couche de conversion, cette ou ces parties s'étendant, autour de la couche de conversion, sur une longueur totale (longueur qui est éventuellement une longueur cumulée) supérieure à la moitié de la longueur dudit pourtour (c'est-à-dire sur une longueur totale qui représente la majeure partie de la longueur dudit pourtour). A titre d'exemple, si la couche de conversion a une section carrée de côté c, son pourtour a une longueur égale à 4c, et la surface réfléchissante du réflecteur s'étend alors en vis-à-vis d'une ou plusieurs parties de la surface latérale de cette couche qui occupent, autour de cette couche, une longueur supérieure à 2c.

Cette disposition permet d'augmenter encore les dimensions «effectives» du réseau de diffraction, en permettant au deuxième rayonnement d'effectuer plusieurs aller et retour dans la couche de conversion puisque le réflecteur confine alors le deuxième rayonnement latéralement en le maintenant en quelque sorte dans la couche de conversion.

On peut d'ailleurs prévoir aussi que la surface réfléchissante du réflecteur comprenne au moins une première face réfléchissante et une deuxième face réfléchissante, chaque face réfléchissante s'étendant transversalement par rapport à la couche de conversion, face à une partie de la surface latérale de la couche de conversion, la deuxième face réfléchissante étant située à l'opposé de la première face réfléchissante par rapport à la couche de conversion, les première et deuxième faces réfléchissantes étant sensiblement parallèles entre elles.

Cette disposition permet simplement, par réflexions successives sur les faces réfléchissantes en question, de faire faire un grand nombre d'aller-retours, dans la couche de conversion, au deuxième rayonnement. Cette disposition permet donc d'obtenir simplement une longueur effective de réseau nettement plus grande que sa longueur géométrique «réelle» (non seulement deux fois plus grande, mais même 10, voire 20 fois plus grande, grâce à ce grand nombre d'aller-retour).

Outre les caractéristiques mentionnées ci-dessus, le dispositif optoélectronique qui vient d'être présenté peut comprendre une ou plusieurs caractéristiques complémentaires et non-limitatives suivantes, considérées individuellement ou selon toutes les combinaisons techniquement envisageables :

-    le réflecteur est formé, au moins superficiellement, d'un métal ;

-    la face supérieure de la couche de conversion s'étend sur une aire inférieure à 1000 microns carrés, voire inférieure à 100 microns carrés ou même inférieure à 10 microns carrés ;

-    la diode électroluminescente comprend une couche active d'où est émis le premier rayonnement et le dispositif comprend en outre un système de confinement latéral qui inclut ledit réflecteur latéral, qui s'étend axialement depuis la couche active jusqu'à la couche de conversion et qui est configuré pour confiner latéralement le premier rayonnement;

-    le dispositif comprend en outre un premier filtre réfléchissant multicouche qui s'étend entre la diode électroluminescente et le puit quantique planaire et qui est au moins partiellement réfléchissant pour le deuxième rayonnement ;

-    le dispositif comprend en outre un deuxième filtre réfléchissant multicouche qui s'étend au-dessus du puit quantique planaire et qui est au moins partiellement réfléchissant pour le premier rayonnement.

Un autre aspect de l'invention concerne un pixel comprenant :

-    un dispositif optoélectronique tel que décrit ci-dessus, et

-    un dispositif optoélectronique d'émission de lumière supplémentaire comprenant :

-    une diode électroluminescente supplémentaire, configurée pour émettre ledit premier rayonnement,

- une couche de conversion supplémentaire qui s'étend au-dessus de la diode électroluminescente supplémentaire et qui est configurée pour convertir une partie au moins du premier rayonnement en un troisième rayonnement, par photoluminescence, la couche de conversion supplémentaire étant délimitée latéralement une surface latérale, la couche de conversion supplémentaire comprenant au moins un puit quantique planaire supplémentaire configuré pour émettre le troisième rayonnement, un réseau de diffraction supplémentaire, configuré pour extraire une partie au moins du troisième rayonnement de la couche de conversion supplémentaire, étant gravé sur une face supérieure de la couche de conversion supplémentaire, et

- un réflecteur latéral supplémentaire ayant une surface réfléchissante dont une partie au moins s'étend transversalement par rapport à la couche de conversion supplémentaire, face à la surface latérale de la couche de conversion supplémentaire.

L'invention concerne aussi un pixel, tel que décrit ci-dessus, comprenant encore un autre dispositif optoélectronique d'émission de lumière qui comporte une autre diode électroluminescente configurée pour émettre ledit premier rayonnement et qui est :

- soit dépourvu de couche de conversion,

- soit muni d'une couche de conversion additionnelle, configurée pour convertir une partie au moins du premier rayonnement en un quatrième rayonnement différent des deuxième et troisième rayonnements.

L'invention concerne aussi un afficheur comprenant une matrice de pixels tels que décrits ci-dessus.
L'invention concerne aussi un procédé de fabrication d'un dispositif optoélectronique d'émission de lumière, comprenant les étapes suivantes :

- réalisation d'une diode électroluminescente configurée pour émettre un premier rayonnement ;

- réalisation d'une couche de conversion, qui s'étend au-dessus de la diode électroluminescente et qui est configurée pour convertir une partie au moins du premier rayonnement en un deuxième rayonnement, par photoluminescence, la couche de conversion étant délimitée latéralement par une surface latérale ;

- dans lequel l'étape de réalisation de la couche de conversion comprend une étape de réalisation d'un puit quantique planaire configuré pour émettre le deuxième rayonnement,

- le procédé comprenant en outre les étape suivantes :

    - gravure d'un réseau de diffraction sur une face supérieure de la couche de conversion, le réseau de diffraction étant configuré pour extraire une partie au moins du deuxième rayonnement de la couche de conversion, et

    - réalisation d'un réflecteur latéral ayant une surface réfléchissante qui s'étend transversalement par rapport à la couche de conversion, en face d'une partie au moins de la surface latérale de la couche de conversion, la surface réfléchissante du réflecteur et la surface latérale de la couche de conversion étant séparées l'une de l'autre par un matériau ayant un indice optique $n_2$, et dans lequel une distance séparant la surface réfléchissante du réflecteur de la surface latérale de la couche de conversion est comprise entre $\lambda/(n_2 \times 40)$ et $\lambda/(n_2 \times 2)$ où $\lambda$, est la longueur d'onde moyenne du deuxième rayonnement.

Dans ce procédé, on peut prévoir que la diode électroluminescente soit réalisée sur un premier substrat, le procédé comprenant en outre une encapsulation de la diode électroluminescente et une planarisation d'une surface de contact située au-dessus de la diode électroluminescente, et que l'étape de réalisation de la couche de conversion comprenne les étapes suivantes :

- sur un deuxième substrat, réalisation d'un empilement comprenant ledit puit quantique planaire,

- placer ledit empilement sur ladite surface de contact, au contact de ladite surface de contact, et fixer ledit empilement à la surface de contact, et

- retirer le deuxième substrat.

Le procédé présenté ci-dessus peut en outre être réalisé de manière à ce que le dispositif produit comprenne une ou plusieurs des caractéristiques optionnelles décrites plus haut, lors de la présentation du dispositif.

L'invention concerne aussi un procédé de fabrication d'un pixel, comprenant les étapes suivantes :

- réalisation d'une première, deuxième et troisième diodes électroluminescentes, configurées chacune pour émettre un premier rayonnement,

- réalisation d'une couche de conversion, qui s'étend au-dessus de la troisième diode électroluminescente et qui est configurée pour convertir une partie au moins du premier rayonnement en un troisième rayonnement, par photoluminescence, la couche de conversion étant délimitée latéralement par une surface latérale, ladite étape de réalisation comprenant :

    - une étape de réalisation d'au moins un puit quantique planaire configuré pour émettre le troisième rayonnement, et

    - une étape de gravure d'un réseau de diffraction sur une face supérieure de la couche de conversion, le réseau de diffraction étant configuré pour extraire une partie au moins du troisième rayonnement de la couche de conversion,

- réalisation d'une couche de conversion, qui s'étend au-dessus de la deuxième diode électroluminescente et qui est configurée pour convertir une partie au moins du premier rayonnement en un deuxième rayonnement, par photoluminescence, la couche de conversion étant délimitée latéralement par une surface latérale, ladite étape de réalisation comprenant :

    - une étape de réalisation d'au moins un puit quantique planaire configuré pour émettre le deuxième rayonnement, et

    - une étape de gravure d'un réseau de diffraction sur une face supérieure de la couche de conversion, le réseau de diffraction étant configuré pour extraire une partie au moins du deuxième rayonnement de la couche de conversion,

- pour chaque couche de conversion, réalisation d'un réflecteur latéral ayant une surface réfléchissante qui s'étend transversalement par rapport à la couche de conversion considérée, en face d'une partie au moins de la surface latérale de cette couche de conversion, la surface réfléchissante du réflecteur et la surface latérale de la couche de conversion considérée étant séparées l'une de l'autre par un matériau ayant un indice optique $n_2$, et dans lequel une distance séparant la surface réfléchissante du réflecteur de la surface latérale de la couche de conversion considérée est comprise entre $\lambda/(n_2 \times 40)$ et $\lambda/(n_2 \times 2)$ où $\lambda$, est la longueur d'onde moyenne du deuxième rayonnement, ou, respectivement du troisième rayonnement.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

La figure 1 représente schématiquement un pixel mettant en oeuvre les enseignements de l'invention, en coupe et vu de côté.

La figure 2 représente schématiquement l'un des dispositifs d'émission du pixel de la figure 1, vu de dessus.

La figure 3 représente schématiquement un réseau de diffraction du dispositif d'émission de la figure 2.

La figure 4 représente schématiquement la section d'un faisceau lumineux produit par le dispositif d'émission de la figure 2.

La figure 5 représente schématiquement la section d'un faisceau lumineux produit par le dispositif d'émission similaire au dispositif de la figure 2, mais muni d'un autre réseau de diffraction.

La figure 6 représente schématiquement un autre mode de réalisation du dispositif d'émission de la figure 2, vu de côté, en coupe.

La figure 7 représente schématiquement des étapes d'un procédé de fabrication du dispositif de la figure 1.

La figure 8 représente schématiquement plus en détail certaines étapes du procédé de la figure 7.

La figure 9 représente schématiquement et partiellement le pixel de la figure 1, à un stade intermédiaire de sa fabrication, en coupe et vu de côté.

La figure 10 représente schématiquement et partiellement le pixel de la figure 1, à un autre stade intermédiaire de sa fabrication, en coupe et vu de côté.

La figure 11 représente schématiquement et partiellement le pixel de la figure 1, à un autre stade, ultérieur, de sa fabrication, en coupe et vu de côté.

La figure 12 représente schématiquement le pixel de la figure 1, juste après une étape de réalisation d'une couche de conversion par photoluminescence, en coupe et vu de côté.

La figure 13 représente schématiquement le pixel de la figure 1, à un stade intermédiaire de sa fabrication, après le report d'un empilement destiné à réaliser une autre couche de conversion par photoluminescence.

La figure 14 représente schématiquement le pixel de la figure 1, juste après une étape de réalisation d'une autre couche de conversion, en coupe et vu de côté.

## DESCRIPTION DETAILLEE

Dans le cadre du présent document, on emploie indifféremment les termes « diode électroluminescente », « DEL » et « LED » (de l'anglais « light-emitting diode »).

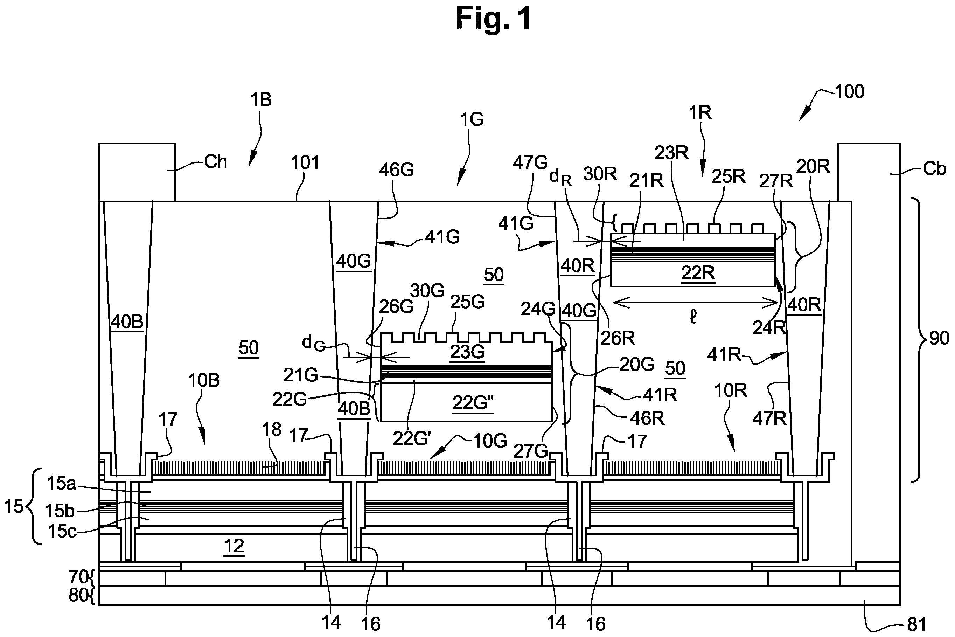

Un dispositif optoélectronique d'émission de lumière 1R, 1G est décrit dans la figure 1. Un tel dispositif est inventif, quand il comprend toutes les caractéristiques de la revendication 1. Le dispositif optoélectronique d'émission de lumière 1R, 1G comprend (figure 1) :

- une diode électroluminescente pompée électriquement, 10R, 10G, configurée pour émettre un premier rayonnement lumineux dont le spectre s'étend principalement dans une bande de longueurs d'onde donnée, par exemple entre 400 et 490 nanomètres, et qui a par exemple une couleur correspondant à un bleu, et
- une couche de conversion 20R, 20G, qui s'étend au-dessus de la diode électroluminescente 10R, 10G et qui est configurée pour convertir une partie au moins du premier rayonnement par photoluminescence, de manière à obtenir un autre rayonnement lumineux, ayant par exemple une couleur rouge ou verte.

Un tel dispositif optoélectronique 10R, 10G trouve une application particulièrement intéressante dans la réalisation d'un pixel 100 «en couleurs», tel que celui représenté sur figure 1, capable d'émettre un rayonnement lumineux d'ensemble dont la couleur peut être ajustée électriquement.

Pour réaliser un tel pixel 100, on peut par exemple regrouper :

- un premier dispositif optoélectronique d'émission de lumière, 1B, comprenant une LED 10B pompée électriquement, configurée pour émettre le premier rayonnement lumineux mentionné ci-dessus (ce premier rayonnement ayant en l'occurrence une couleur correspondant à un bleu), le premier dispositif 1B étant dépourvu de couche de conversion,

- un deuxième dispositif optoélectronique d'émission de lumière, 1R, tel que décrit plus haut, la couche de conversion 20R de ce dispositif 1R étant configurée pour émettre un deuxième rayonnement lumineux, par photoluminescence, le deuxième rayonnement lumineux ayant par exemple une couleur correspondant à un rouge et un spectre situé principalement entre 590 et 700 nanomètres, et

- un troisième dispositif optoélectronique d'émission de lumière 1G, tel que décrit plus haut, la couche de conversion 20G de ce dispositif 1G étant configurée pour émettre un troisième rayonnement lumineux, par photoluminescence, le troisième rayonnement lumineux ayant par exemple une couleur correspondant à un vert et un spectre situé principalement entre 490 et 590 nanomètres.

Un tel pixel en «couleurs», basé sur trois diodes électroluminescentes «bleues» 10B, 10R, 10G dont deux sont pourvues d'une couche de conversion 20R, 20G, est particulièrement intéressant car la fabrication de diodes électroluminescentes «bleues» est aujourd'hui bien maitrisée, et car leur efficacité lumineuse est élevée. En outre, dans cet arrangement, deux couches de conversion seulement sont nécessaires pour produire trois rayonnements ayant des couleurs distinctes, en l'occurrence un rouge, un vert et un bleu (ce qui permet, pour le rayonnement d'ensemble émis, qui correspond à la combinaison de ces trois rayonnements, d'obtenir une couleur ajustable dans une large gamme de couleurs).

En variante, les gammes de longueurs d'onde employées, et la structure du pixel pourrait toutefois être différentes de celles présentées ci-dessus.

Par exemple, les LEDs pompées électriquement 10R, 10B et 10G pourraient être configurées de manière à ce que le premier rayonnement qu'elles émettent soit situé dans le proche ultraviolet (auquel cas le premier dispositif serait lui aussi pourvu d'une couche de conversion), au lieu d'être situé dans le visible. Ou encore, elles pourraient être configurées de manière à ce que la couleur du premier rayonnement corresponde à un violet au lieu de correspondre à un bleu.

Par ailleurs, le pixel pourrait comprendre un nombre de dispositifs élémentaires d'émission de lumière différent de trois. Il pourrait par exemple comprendre, en plus des trois dispositifs d'émission mentionnés ci-dessus, un quatrième dispositif d'émission configuré pour émettre dans le rouge, du même type que le deuxième dispositif 1R (le pixel comprenant alors deux dispositifs pour l'émission dans le rouge, un dispositif pour l'émission dans le bleu, et un dispositif pour l'émission dans le vert). Au contraire, le pixel pourrait comprendre seulement deux dispositifs d'émission de lumière, par exemple un pour l'émission dans le rouge et un pour l'émission dans le bleu. D'une manière générale, on peut prévoir un autre nombre de sous-pixels (par pixel) que ce qui a été indiqué ci-dessus, d'autres longueurs d'onde d'émission et/ou d'autres formes de réplication de sous-pixels au sein d'un même pixel. Un ensemble de sous-pixels forme un pixel qui peut être répliqué plusieurs fois pour former une matrice.

D'ailleurs, même si les dispositifs d'émission de lumière individuels 1R et 1G sont regroupés ici pour former des pixels 100 en couleurs, chacun de ces dispositifs d'émission 1R, 1G peut être considéré seul, et pourrait d'ailleurs être employé seul pour réaliser une source de lumière. Le pixel 100 lui aussi peut être considéré seul, et être employé seul pour réaliser une source de lumière en couleurs élémentaire (en d'autres termes, il n'est pas nécessairement intégré à une matrice de pixels).

Un afficheur en couleurs, capable de générer, c'est-à-dire d'afficher une image en couleurs peut être réalisé en regroupant plusieurs pixels tels que celui, 100, présenté plus haut. Ces pixels 100 sont alors regroupés sous la forme d'une matrice de pixels.

Un afficheur monochrome pourrait néanmoins être réalisé aussi, en regroupant sous la forme d'une matrice plusieurs dispositifs d'émission identiques, tels que le dispositif 1R, ou tels que le dispositif 1G.

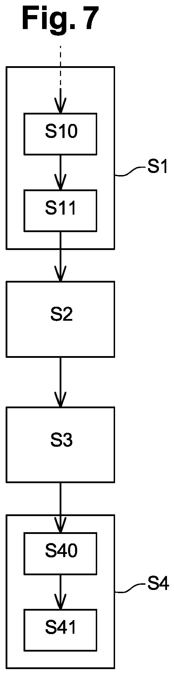

La structure du pixel 100 est maintenant décrite plus en détail, en référence aux figures 1 à 6. Un procédé de fabrication d'un tel pixel, et, plus généralement, d'un afficheur comprenant une matrice de pixels 100 de ce type, sera présenté ensuite, en référence aux figures 7 à 14.

Le pixel 100, et plus généralement l'afficheur qui regroupe plusieurs pixels 100 de ce type, comprend un empilement de conversion 90, qui s'étend au-dessus des LEDs 10R, 10G, 10B pompées électriquement (au-dessus des LEDs «bleues»), et qui inclut les couches de conversion 20R, 20G mentionnées plus haut (figure 1). Cet empilement de conversion 90 a une structure remarquable, qui permet une conversion par photoluminescence particulièrement efficace (ici vers le vert, et vers le rouge).

La partie inférieure du pixel 100, qui comprend les LEDs 10R, 10G, 10B pompées électriquement (LEDs «bleues»), sera décrite dans un premier temps, et on décrira ensuite cet empilement de conversion 90 particulier.

Les première, deuxième et troisième LEDs 10B, 10R, 10G pompées électriquement sont ici identiques, ou tout au moins similaires entre elles. Elles sont agencées sur un empilement d'interconnexion 70, qui permet de les alimenter électriquement de manière sélective, c'est-à-dire indépendamment les unes des autres. L'empilement d'interconnexion est lui-même agencé sur un circuit intégré de contrôle 80.

Ici, chaque LED pompée électriquement 10B, 10R et 10G comporte une couche active 15 qui comprend un ou plusieurs puits quantiques planaires, pour l'émission du premier rayonnement.

La couche active 15 peut, comme ici, être formée par un empilement comportant, dans cet ordre, depuis le haut vers le bas :

- une couche 15a de nitrure de gallium dopé de type N,

- une couche émissive 15b, qui comporte le ou les puits quantiques planaires mentionnés ci-dessus, et

- une couche 15c de nitrure de gallium dopé de type P.

Cet empilement est déposé sur une couche métallique de contact d'anode, 12. La couche métallique 12 s'étend donc sous la couche 15c de nitrure de gallium dopé de type P, en contact électrique avec celle-ci.

L'émission du premier rayonnement est obtenue en injectant un courant électrique dans la LED 10B, 10R, 10G, ce courant traversant alors la couche active 15 depuis la région d'anode de cette hétérojonction, formée par la couche 105c, jusqu'à sa région de cathode, formée par la couche 105a.

L'expression «puit quantique planaire», ou plus simplement «puit quantique», désigne ici une structure comprenant:

- une couche centrale, mince, formée d'un premier matériau semi-conducteur ayant une première bande interdite, et

- deux couches barrières qui enserrent la couche centrale, chaque couche barrière étant formée d'un deuxième matériau semi-conducteur ayant une deuxième bande interdite plus large que la première bande interdite (les deux couches barrières pouvant éventuellement être formées respectivement de deux matériaux semi-conducteurs différents l'un de l'autre), ou, au lieu des deux couches barrières, d'un matériau semiconducteur massif qui enserre la couche centrale et qui a une bande interdite plus large que la première bande interdite.

La couche centrale, mince, forme un puit de potentiel pour les électrons et/ou les trous (ce qui explique la dénomination de «puit quantique» donnée à cette structure). Ce puit est planaire en ce sens qu'il s'étend dans un plan, de manière bidimensionnelle, puisque la couche centrale est elle-même plane. La couche centrale, mince, a une épaisseur qui est comprise typiquement entre 3 et 15 nanomètres. Son épaisseur est nettement plus petite que ses dimensions latérales, parallèlement au plan de la couche (largeur et la longueur).

Le ou les puits quantiques de la couche émissive 15b sont configurés de manière à émettre le premier rayonnement mentionné plus haut, c'est-à-dire, ici, de manière à émettre un rayonnement lumineux dont le spectre est contenu principalement dans la bande de longueurs d'onde qui s'étend de 400 nanomètres à 490 nanomètres. Ce sont plus précisément l'épaisseur de la couche centrale de chacun de ces puits et le premier matériau semi-conducteur qui forme cette couche centrale qui sont choisis de manière à ce que le premier rayonnement ait le spectre voulu. Pour obtenir comme ici une émission dans le bleu, on peut par exemple choisir, pour le premier matériau semiconducteur (couche centrale), du nitrure d'indium-gallium InGaN, le deuxième matériau semi-conducteur étant quant à lui du nitrure de gallium GaN.

Les matériaux semi-conducteurs choisis pourraient néanmoins être différents, en particulier si l'on cherche à émettre le premier rayonnement lumineux dans une gamme de longueurs d'onde différente de celle indiquée ci-dessus (différente de la gamme allant de 400 à 490 nm).

Ainsi, lorsque l'on souhaite plus généralement obtenir une émission dans une bande de longueurs d'onde donnée du domaine du visible (380 à 700 nm), on pourra réaliser la couche active 15 à base de matériaux semi-conducteurs III-V, c'est-à-dire comprenant un élément de la colonne V du tableau périodique des éléments, par exemple de l'azote N, de l'arsenic As ou du phosphore P, associé à un ou plusieurs éléments de la colonne III du tableau périodique des éléments, par exemple du gallium Ga, de l'aluminium Al et/ou de l'indium In. Des exemples de matériaux semi-conducteurs III-V sont ainsi le nitrure de gallium GaN, le nitrure d'indium InN, le nitrure d'aluminium AlN, le phosphure de gallium GaP, le phosphure d'indium InP, le nitrure d'indium-gallium InGaN, le nitrure d'aluminium-gallium AlGaN, le nitrure d'indium-gallium InGaN, le phosphure d'aluminium-gallium AlGaP, le phosphure d'aluminium-indium-gallium AlInGaP, le nitrure d'indium-gallium-aluminium InGaAlN. En variante, le premier matériau semi-conducteur, qui forme la couche centrale du ou des puits quantiques, pourrait donc être choisi parmi les matériaux suivants : GaN, InP, AlGaN, AlN, AlInGaN, GaP, AlGaP, InGaP, AlInGaP, GaAs, ou AlGaAsN qui sont des composés binaires, ternaires ou quaternaires de ces éléments III-V.

Les caractéristiques de la couche émissive 15b peuvent être choisies par ailleurs de manière à ce que le spectre du premier rayonnement lumineux émis ait une largeur à mi-hauteur inférieure à un seuil donné, par exemple inférieure à 30 nm.

Dans l'exemple représenté, chaque LED pompée électriquement, 10R, 10G, 10B, comprend une couche supérieure texturée 18, par exemple en semiconducteur gravé, qui s'étend au-dessus de la couche de cathode 15a, contre celle-ci. Cette couche texturée forme un cristal photonique qui constitue un réseau de diffraction améliorant l'efficacité avec laquelle le premier rayonnement est extrait de la LED correspondante.

Dans l'exemple représenté, les différentes LEDs 10R, 10G, 10B du pixel 100, et plus généralement de l'afficheur, sont séparées les unes des autres par des tranchées sensiblement verticales (c'est-à-dire sensiblement perpendiculaires au plan de la couche active 15 des LEDs). Ces tranchées sont réalisées dans un empilement de couches (en l'occurrence les couches 12 et 15a à 15c), qui, initialement, est d'un seul tenant, avec une très grande extension latérale. Cet empilement est en quelque sorte découpé en îlots par ces tranchées pour délimiter une pluralité d'îlots ou mesas correspondant aux différentes LEDs du pixel 100 (ou plus généralement, de l'afficheur).

Dans l'exemple représenté, ces tranchées traversent entièrement les couches 12, 15c, 15b et 15a de l'empilement. Les faces latérales des tranchées sont revêtues d'une couche isolante 14, par exemple en oxyde de silicium. Les faces latérales de chaque LED 10R, 10G, 10B sont donc revêtues par cette couche isolante 14, ici en oxyde de silicium. Les tranchées sont ensuite remplies d'un métal qui forme une paroi latérale 16 qui isole optiquement les LEDs les unes des autres. Pour chaque LED, cette paroi latérale 16 confine latéralement le premier rayonnement émis par la LED, ce qui évite que ce rayonnement ne se propage jusqu'à une LED voisine. Cela réduit donc le crosstalk (diaphonie) entre LEDs voisines, crosstalk qui affecterait la pureté du rouge ou du vert produit par les deuxième et troisième dispositifs 1R, 1G du pixel 100.

Telle que représentée, la parois latérale 16 en métal s'étend verticalement sur toute la hauteur de la LED, depuis le bas de la couche métallique de contact 12 jusqu'à la partie supérieure de la couche de cathode 15a. En variante, cette paroi latérale pourrait toutefois s'étendre seulement depuis une face inférieure de la couche active 15 jusqu'à une face supérieure de cette couche, par exemple. Cette disposition permet en effet elle-aussi de confiner latéralement le rayonnement produit par la LED considérée.

Un élément de reprise de contact 17, en contact avec la paroi latérale 16 métallique, est réalisé sur le dessus de la tranchée. Cet élément, électriquement conducteur, a ici la forme d'un canal en U, ouvert du côté supérieur. Il est en contact électrique avec la couche 15a de nitrure de gallium dopé de type N.

Comme déjà indiqué, les LEDs 10R, 10G, 10B sont réalisées ici sur un empilement d'interconnexion 70. Cet empilement comporte typiquement une ou plusieurs couches isolantes, une ou plusieurs couches métalliques, et un ou plusieurs niveaux de vias conducteurs.

Le circuit intégré de contrôle 80 est typiquement formé dans et sur un substrat semiconducteur 81, par exemple un substrat en silicium. Le circuit de contrôle 80 comprend par exemple, pour chaque LED, une cellule élémentaire de contrôle (non détaillée), reliée électriquement à la couche de contact 12 de la LED et comportant un ou plusieurs transistors permettant de contrôler le courant circulant dans la LED et/ou la tension appliquée à la LED. Le circuit de contrôle 80 est par exemple réalisé en technologie CMOS.

On peut prévoir que les cathodes des différentes LEDs 10R, 10G, 10B (plus précisément leurs couches de cathode 15a) soient en contact électrique les unes avec les autres, directement, c'est-à-dire par l'intermédiaire seulement d'un ou plusieurs conducteurs métalliques, et soient chacune reliée électriquement, directement à un contact Ch commun formant un plot d'alimentation électrique (figure 1). En d'autres termes, on peut prévoir que les différentes LEDs 10R, 10G, 10B aient, d'un point de vue électrique, des cathodes communes.

En variante, les différentes LEDs de l'afficheur pourraient être agencées différemment les unes par rapport aux autres. Et un autre système de contact pourrait être employé. Ainsi, pourrait prévoir par exemple que les anodes des différentes LEDs (plus précisément leurs couches d'anode) soient en contact électrique les unes avec les autres, directement, et soient reliée électriquement, directement à un contact Cb commun formant un plot d'alimentation électrique (ces différentes LEDs ayant alors, d'un point de vue électrique, des anodes communes).

On notera que les pixels 100 de cet afficheur sont des pixels de petites dimensions. En effet, pour chacun de ces pixels, les dispositifs optoélectroniques d'émission de lumière 1R, 1G et 1B occupent chacun une surface inférieure à 3000 microns$^2$ (3000 microns carrés), voire inférieure à 1000 microns$^2$ ou même inférieure à 100 microns$^2$.

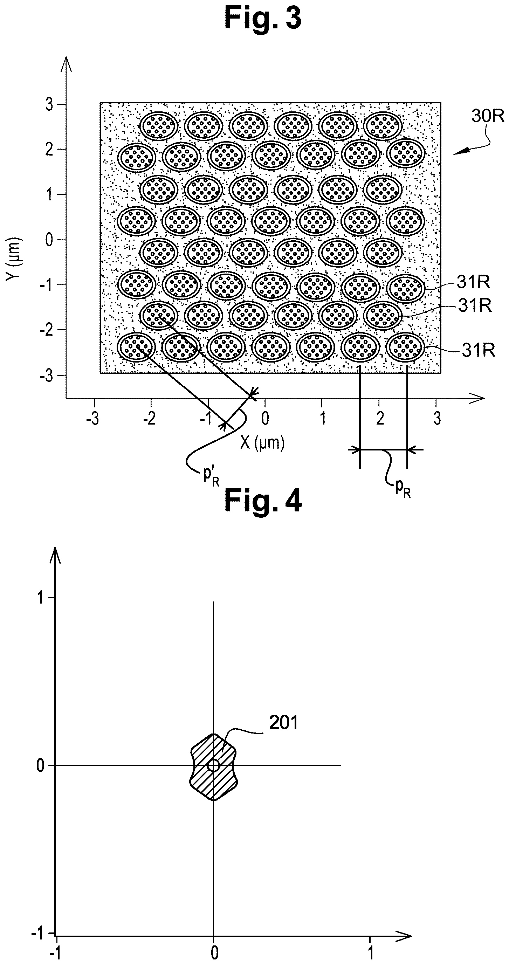

Chacun de ces dispositifs d'émission a donc une surface d'émission réduite. On peut ainsi prévoir, par exemple, que chacun de ces dispositifs 1R, 1G, 1B ait des dimensions (par exemple une largeur, une longueur, ou un diamètre), dans un plan parallèle au plan moyen du pixel (c'est-à-dire parallèle au plan du substrat 81 sur lequel on réalise les diodes électroluminescentes) qui soient chacune inférieure à 30 microns, voire inférieure à 10 microns ou même inférieure à 6 microns. Chacun de ces dispositifs peut par exemple occuper, sur le substrat 81, une surface carrée de 20, de 10 ou de 6 microns de côtés (comme dans le cas de la figure 3), voire moins. Chacun de ces dispositifs pourrait aussi, par exemple, occuper une surface rectangulaire de 10 microns de large et 30 microns de long (ou moins), ou encore de 6 microns de large et 15 microns de long, par exemple. L'invention s'applique d'ailleurs de manière particulièrement intéressante à des dispositifs de dimensions particulièrement petites, par exemple des dispositifs de 3 microns de côté ou moins.

L'empilement de conversion 90 est décrit maintenant plus en détails.

Cet empilement comprend notamment :

- la couche de conversion 20R mentionnée plus haut (couche de conversion vers le rouge), située au-dessus de la LED 10R du deuxième dispositif d'émission 1R, au droit de cette LED, et

- la couche de conversion 20G (couche de conversion vers le vert), située au-dessus de la LED 10G du troisième dispositif d'émission 1G, au droit de cette LED.

La couche de conversion 20R du deuxième dispositif d'émission 1R est formée par un empilement de couches en matériau semi-conducteur. L'extension latérale de cet empilement, c'est-à-dire la surface qu'il occupe dans un plan parallèle au plan moyen du pixel 100, est limitée et coïncide sensiblement avec l'extension latérale de la LED 10R, pompée électriquement. Autrement formulé, la couche de conversion 20R recouvre la LED 10R mais ne recouvre pas les autres LEDs 10B, 10G du pixel 100. La surface latérale de la couche de conversion 20R, qui délimite latéralement cette couche, est repérée par la référence 24R.

De manière comparable, la couche de conversion 20G du troisième dispositif d'émission 1G est formée par un empilement de couches en matériau semi-conducteur, dont l'extension latérale est limitée à l'extension latérale de la LED 10G. La surface latérale de la couche de conversion 20G, qui délimite latéralement cette couche, est repérée par la référence 24G.

La couche de conversion 20R ne s'étend pas directement au contact de la LED 10R. La couche de conversion 20R est au contraire séparée de la face supérieure de la LED 10R par une certaine distance, axialement (c'est-à-dire dans une direction perpendiculaire au plan moyen du pixel 100). L'espace situé entre la LED 10R et la couche de conversion 20R est rempli par un matériau de remplissage 50 transparent, par exemple de l'oxyde de silicium SiO$_2$. Ce

matériau de remplissage 50 recouvre aussi la couche de conversion 20R et l'entoure latéralement. La couche de conversion 20R est donc noyée dans le matériau de remplissage 50, ici.

De la même manière, la couche de conversion 20G est séparée de la face supérieure de la LED 10G par une certaine distance, axialement, et l'espace situé entre la LED 10G et la couche de conversion 20G est rempli par le matériau de remplissage 50. La couche de conversion 20G est elle aussi noyée, c'est-à-dire englobée, dans le matériau de remplissage 50.

La structure des couches de conversion 20R, 20G est maintenant décrite plus en détail.

La couche de conversion 20R du deuxième dispositif 1R comprend au moins un puit quantique planaire 21R, configuré pour émettre le deuxième rayonnement (rayonnement situé ici dans la gamme de longueur d'onde allant de 600 à 700 nm). Les matériaux semiconducteurs employés pour réaliser ce ou ces puits quantiques peuvent par exemple être du Phosphorure d'Aluminium-Indium-Galium AlInGaP et du Phosphorure d'Indium-Gallium InGaP.

Le puit quantique 21R de cette couche 20R, ou l'ensemble des puits quantiques 21R de cette couche, est enserré entre une couche inférieure 22R et une couche supérieure 23R, qui forment une sorte de revêtement pour le ou les puits quantiques (revêtement parfois appelé «cladding» en anglais). Chacune de ces couches 22R, 23R est réalisée par exemple en phosphorure d'aluminium-indium-galium, AlInGaP.

La couche inférieure 22R, située en dessous du ou des puits quantiques 21R, est donc intercalée entre la LED 10R et ce ou ces puits 21R. La couche inférieure 22R a par exemple une épaisseur comprise entre 0,1 et 0,5 micron. La couche supérieure 23R peut aussi avoir une épaisseur comprise entre 0,1 et 0,5 micron, par exemple.

En pratique, le nombre de puits quantiques 21R est typiquement compris entre 1 et 5. On notera à ce propos que pour la conversion du bleu vers le rouge, un seul puit quantique peut s'avérer suffisant pour convertir la majeure partie du premier rayonnement. Lors de cette conversion, le premier rayonnement est absorbé dans les couches barrière des puits 21R (ou dans le cladding 22R, 23R), et les paires électron-trou ainsi créées se recombinent ensuite radiativement dans le ou les puits, émettant ainsi le deuxième rayonnement.

La couche de conversion 20R est délimitée en partie supérieure par une face supérieure 25R (il s'agit ici de la face supérieure de la couche supérieure 23R).

Cette face supérieure 25R est texturée : un réseau de diffraction 30R, qui forme un cristal photonique uni ou bi-dimensionnel, est gravé sur cette face. Ce réseau est configuré pour améliorer l'efficacité avec laquelle le deuxième rayonnement est extrait de la couche de conversion 20R, par rapport à une interface complètement plane, sans relief.

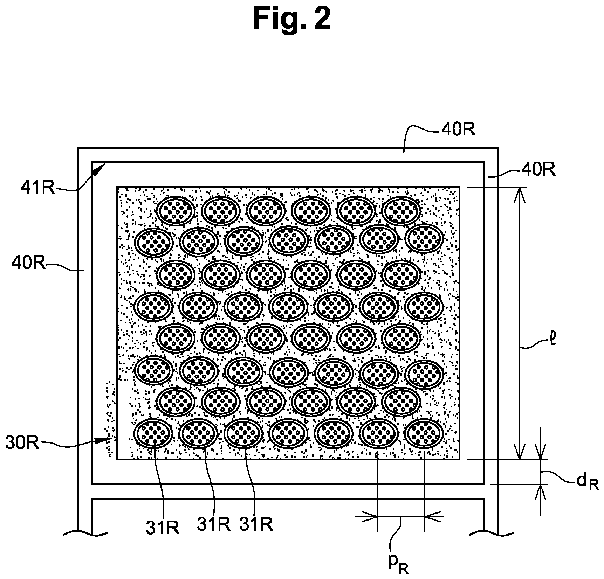

Le réseau de diffraction 30R est visible sur la figure 3, ainsi que sur la figure 2 qui représente schématiquement le deuxième dispositif 1R, vu de dessus.

Dans cet exemple, le réseau de diffraction 30R, ou, en d'autres termes, le réseau d'extraction, est un réseau bidimensionnel. Il comporte ainsi un même motif 31R répété périodiquement dans deux directions différentes du plan du réseau (plan qui est le plan de la face supérieure 25R). En l'occurrence, il s'agit d'un réseau triangulaire (dont la maille élémentaire est par exemple un triangle équilatéral). Mais, en variante, il pourrait s'agir d'un réseau ayant une maille différente, par exemple rectangulaire, ou hexagonale. Quant au motif 31R, répété périodiquement, il peut s'agir aussi bien de trous que de piliers. Le réseau de diffraction en question pourrait aussi être un réseau uni-dimensionnel, formé de rainures parallèles les unes aux autres et espacées régulièrement (répétées périodiquement).

Ce réseau permet d'améliorer l'efficacité d'extraction du deuxième rayonnement, mais il permet aussi de donner au faisceau lumineux extrait une direction, une forme, et éventuellement une polarisation déterminées. Cela permet d'adapter le rayonnement émis par dispositif 1R à l'application visée pour ce dispositif, avec beaucoup de souplesse.

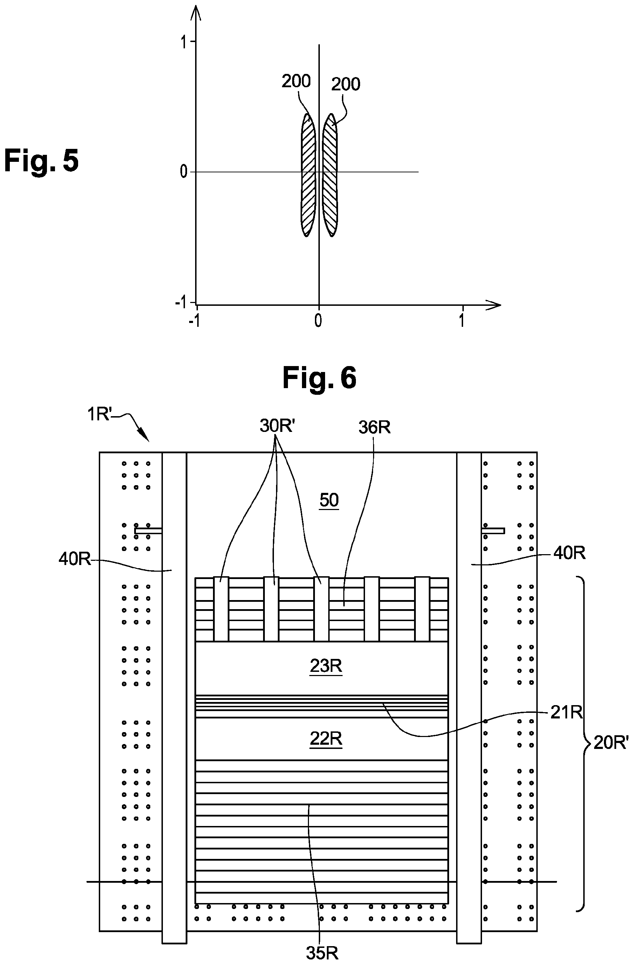

Ainsi, par exemple, si une polarisation dominante selon un axe est souhaitée, on emploiera de préférence un réseau uni-dimensionnel. Avec un tel réseau, le faisceau lumineux émis sera composé principalement de deux nappes de lumière, légèrement écartées l'une de l'autre d'un point angulaire, et ayant des sections transverses de forme allongée, parallèles l'une à l'autre, comme on peut le voir sur la figure 5. Cette figure montre, en champ lointain et dans un plan parallèle au plan du réseau, la section 200 du faisceau extrait par un réseau unidimensionnel de quelques microns de côté.

Si l'on souhaite au contraire obtenir un faisceau ayant une section de forme globalement isotrope, par exemple globalement en forme de disque ou d'anneau, on pourra employer un réseau de diffraction bi-dimensionnel à maille hexagonale ou triangulaire (voir la figure 4). Il est à noter que la structure fine du champ lointain respecte la symétrie du cristal photonique. Si le réseau est de maille hexagonale, on retrouvera une symétrie d'ordre 6 (répétition de motifs tous les 60°) dans la structure fine du champ même si celui-ci a globalement une forme isotrope (pour une maille carrée on retrouvera une symétrie 4 avec deux axe de symétries orthogonaux). La figure 4 montre, en champ lointain et dans un plan parallèle au plan du réseau, la section 201 du faisceau extrait par le réseau triangulaire de la figure 3.

D'autres types de réseaux bidimensionnels sont bien sûr envisageables, selon les caractéristiques souhaitées pour le faisceau lumineux extrait.

Le dimensionnement du réseau de diffraction dépend aussi de l'épaisseur des motifs, du contraste d'indice du réseau, et de la longueur d'onde à extraire, qui correspond ici à la longueur d'onde moyenne du deuxième rayonnement notée $\lambda_R$.

De manière générale, le pas $p_R$ du réseau 30R est choisi entre $\lambda_R/(2.n_1)$ et $2 \times \lambda_R$, où $n_1$ est l'indice optique du matériau d'indice fort du réseau, matériau qui correspond au matériau de la couche supérieure 23R de la couche de conversion 20R (en l'occurrence, ici, du phosphorure d'aluminium-indium-galium AlInGaP).

On peut par exemple prévoir que le pas du réseau $p_R$ (ou les pas du réseau $p_R$, $p_{R'}$, dans le cas d'un réseau bi-dimensionnel) soit compris entre $\lambda_R/(2.n_1)$ et $\lambda_R/(n_1)$, ou même entre $\lambda_R/(2.n_1)$ et $(3.\lambda_R)/(4.n_1)$. Choisir ainsi un pas $p_R$ relativement petit, proche de la borne inférieure $\lambda_R/(2.n_1)$ de la gamme de pas envisageables, permet, pour une taille donnée du réseau, de répéter un plus grand nombre de fois le motif diffractant, sur la surface du réseau. Cela améliore donc l'efficacité d'extraction du réseau. Cette amélioration est particulièrement notable ici car le réseau comprend un nombre de répétitions du motif qui reste relativement petit (ce nombre étant par exemple compris entre 5 et 50, pour un réseau unidimensionnel). $\lambda_R$ est ici la longueur d'onde moyenne du deuxième rayonnement.

On notera que le matériau d'indice faible du réseau correspond ici au matériau de remplissage 50, dont l'indice est noté $n_2$.

Comme on peut le voir sur la figure 1, les couches de conversion respectives des deuxième et troisième dispositifs, 20R et 20G, ont des structures similaires.

La couche de conversion 20G du troisième dispositif 1G comprend elle aussi au moins un puit quantique planaire 21G. En l'occurrence, cette couche comprend ici plusieurs puits quantiques 21G, typiquement au moins 2, voire même au moins 5 puits. Il est en effet préférable d'employer au moins deux, voire même au moins 5 puits, pour cette couche de conversion, car la conversion du bleu vers le vert est en général moins efficace que la conversion du bleu vers le rouge. Pour certaines configurations bien spécifiques de matériaux, dans le cade de la conversion du bleu vers le vert avec le matériau GaN par exemple, il est même préférable, comme ici, d'empiler une dizaine, voire plusieurs dizaines de puits quantiques InGaN de manière à absorber la quasi-totalité du faisceau incident bleu.

Chacun de ces puits 21G est configuré pour émettre le troisième rayonnement (rayonnement correspondant ici à un vert, et dont le spectre est situé principalement dans la gamme de longueurs d'onde allant de 490 à 590 nm). Les matériaux semiconducteurs employés pour réaliser ces puits quantiques 21G peuvent par exemple être du nitrure d'indium-gallium InGaN pour la couche centrale du puit, et du nitrure de gallium GaN pour les couches barrière.

L'ensemble des puits quantiques 21G de cette couche est enserré entre une couche inférieure 22G et une couche supérieure 23G, en matériaux semi-conducteurs. La couche supérieure 23G est réalisée par exemple en nitrure de gallium GaN. Quant à la couche inférieure 22G, elle comprend ici :

- une première sous-couche 22G', optionnelle, en nitrure d'aluminium-gallium AlGaN ou en nitrure de gallium GaN, qui s'étend juste sous les puits quantiques 21G, contre le puit quantique situé le plus bas, et qui forme une sous-couche dite de blocage d'électrons (ou «EBL», pour «Electron Blocking Layer», en anglais), et

- sous la première sous-couche, une deuxième sous-couche 22G", en nitrure de gallium GaN, ou en nitrure d'aluminium-gallium AlGaN.

La couche inférieure 22G et la couche supérieure 23G ont par exemple chacune une épaisseur comprise entre 0,1 et 0,8 micron.

Comme pour le deuxième dispositif, la couche de conversion 20G du troisième dispositif 1G est délimitée en partie supérieure par une face supérieure 25G (il s'agit ici de la face supérieure de la couche supérieure 23G).

Cette face supérieure 25G est texturée : un réseau de diffraction 30G, qui forme un cristal photonique uni ou bi-dimensionnel, est gravé sur cette face. Ce réseau est configuré pour améliorer l'efficacité avec laquelle le troisième rayonnement est extrait de la couche de conversion 20G, par rapport à une interface entièrement plane, sans reliefs.

Le réseau de diffraction 30G est comparable au réseau de diffraction 20G du deuxième dispositif, si ce n'est qu'il est configuré pour favoriser l'extraction d'une longueur d'onde $\lambda_G$, égale à la longueur d'onde moyenne du troisième rayonnement, au lieu d'être configuré pour favoriser l'extraction de la longueur d'onde moyenne $\lambda_R$ du deuxième rayonnement.

En particulier, le pas $p_G$ du réseau 30G est compris entre $\lambda_G/(2.n'_1)$ et $2 \times \lambda_G$, au lieu d'être compris entre $\lambda_R/(2.n_1)$ et $2 \times \lambda_R$. $n'_1$ est l'indice optique du matériau d'indice fort du réseau 30G, matériau qui correspond au matériau de la couche supérieure 23G (en l'occurrence, ici, du nitrure de galium GaN).

En plus de leur couche de conversion 20R, 20G, le deuxième et le troisième dispositifs d'émission 1R et 1G comprennent chacune un réflecteur latéral 40R, 40G, ayant une surface réfléchissante 41R, 41G qui s'étend transversalement par rapport à la couche de conversion 20R, 20G, en face d'une partie au moins de la surface latérale 24R, 24G de la couche de conversion 20R, 20G considérée.

Comme expliqué en détail dans la partie intitulée «résumé de l'invention», ce réflecteur latéral permet, d'un point de vue optique, d'augmenter la surface effective du réseau de diffraction 30R, 30G, améliorant ainsi notablement l'efficacité d'extraction du réseau.

Dans l'exemple décrit ici, le réflecteur latéral 40R, 40G de chacun des dispositifs 1R et 1G s'étend non seulement en vis-à-vis d'une partie de la surface latérale 24R, 24G de sa couche de conversion, mais tout autour de cette surface latérale 24R, 24G. En d'autres termes, le réflecteur latéral 40R, 40G s'étend autour de la couche de conversion 20R, 20G considérée, sur tout le pourtour de cette couche.

Chaque couche de conversion 20R, 20G a ici une section rectangulaire, ou éventuellement carrée, dans un plan parallèle au plan moyen du pixel 100.

La surface latérale 24R, 24G de la couche de conversion 20R, 20G est donc formée ici de 4 faces, parallèles deux à deux. Et le pourtour de la couche de conversion 20R, 20G, c'est-à-dire la ligne qui entoure cette couche latéralement (autrement dit, qui borde latéralement la couche de conversion), est donc rectangulaire. La surface réfléchissante 41R, 41G du réflecteur latéral 40R, 40G, qui s'étend tout le long de ce pourtour, comprend elle aussi quatre faces, en l'occurrence planes, qui entourent la couche de conversion. La surface réfléchissante 41R, 41G a elle aussi une section rectangulaire.

Les différentes faces de la surface réfléchissante 41R, 41G s'étendent, respectivement, en vis-à-vis des différentes faces latérales de la couche de conversion 20R, 20G, sensiblement parallèlement à celles-ci (c'est-à-dire en formant avec elles un angle inférieur à 15, voire à 5 degrés).

Le fait que la surface réfléchissante 41R, 41G entoure la couche de conversion 20R, 20G sur tout le pourtour de cette couche est favorable en termes d'efficacité d'extraction. Cela permet en effet de confiner latéralement le deuxième, ou le troisième rayonnement. Grâce à ce confinement, la partie du deuxième, ou du troisième rayonnement qui se propage dans la couche de conversion 20R, 20G, parallèlement à sa face supérieure 25R, 25G, est maintenue dans la couche de conversion où elle effectue des sortes d'aller-retours, ce qui augmente la longueur sur laquelle elle d'interagit avec le réseau de diffraction 30R, 30G, et ce qui augmente donc l'efficacité d'extraction.

En variante, au lieu d'entourer la couche de conversion sur tout le pourtour de cette couche, la surface réfléchissante pourrait toutefois entourer cette couche sur une partie seulement du pourtour de cette couche. Néanmoins, dans ce cas, la surface réfléchissante entoure de préférence la couche de conversion sur la majeure partie du pourtour de cette couche, pour, comme expliqué ci-dessus, obtenir un bon confinement latéral du deuxième, ou troisième rayonnement.

Deux des faces latérales de la surface réfléchissante 41R du deuxième dispositif 1R sont repérées sur la figure 1, par les références 46R et 47R. Ces deux faces sont situées, respectivement, en vis-à-vis des faces latérales 26R et 27R de la couche de conversion 20R.

Comme on peut le voir sur la figure 1, les deux faces latérales 46R et 47R de la surface réfléchissante 41R, qui sont situées à l'opposé l'une de l'autre par rapport à la couche de conversion 20R, sont sensiblement parallèles entre elles, c'est-à-dire qu'elles forment entre elles un angle inférieur à 15 degrés, voir inférieur à 5 degrés. Cette disposition permet simplement, par réflexions successives sur la faces réfléchissantes 46R et 47R, de faire faire un grand nombre d'aller-retours, dans la couche de conversion 20R, à la partie du deuxième rayonnement qui se propage dans cette couche 20R, parallèlement à sa face supérieure 25R. Cette disposition permet donc d'obtenir une longueur effective de réseau nettement plus grande que sa longueur géométrique «réelle» I. A titre de comparaison, pour une surface réfléchissante qui comprendrait une seule face plane réfléchissante, la longueur effective obtenue serait d'environ deux fois la longueur géométrique I du réseau 30R. Alors qu'avec ces deux faces 46R, 47R sensiblement parallèles l'une à l'autre, on obtient une longueur effective 10 fois, voire 20 fois supérieure à la longueur géométrique I du réseau 30R (selon la valeur du coefficient de réflexion de la surface réfléchissante).

Les deux autres faces de la surface réfléchissante 41R, non référencées, forment elles aussi un couple de faces réfléchissantes, planes, sensiblement parallèles entre elles, grâce auxquelles la largeur effective du réseau est démultipliée (par largeur, on désigne ici la dimension du réseau 30R, perpendiculairement au plan de la figure 1).

Deux des faces latérales de la surface réfléchissante 41G du troisième dispositif 1G, situées de part et d'autre de la couche de conversion 20G, sont repérées sur la figure 1 par les références 46G et 47G. Ces deux faces sont situées, respectivement, en vis-à-vis des faces latérales 26G et 27G de la couche de conversion 20G. Comme pour le deuxième dispositif, les deux faces latérales 46G et 47G, planes, sont sensiblement parallèles entre elles. Et il en est de même des deux autres faces latérales de la surface réfléchissante 41G, non référencées.

Pour chacun des dispositifs d'émission 1R et 1G, le réflecteur latéral 40R, 40G a ici une section rectangulaire, pour s'adapter à la forme des LEDs 10R, 10G et à la forme des couches de conversion 20R, 20G, elles-mêmes de section rectangulaire (occupant une surface rectangulaire, dans un plan parallèle au substrat 81).

En variante, ces différents éléments pourraient toutefois avoir une forme différente d'un rectangle, d'un carré ou d'un hexagone. Par exemple, les LEDs, les couches de conversion et les réflecteurs latéraux pourraient avoir une section triangulaire, ou circulaire.

Quoi qu'il en soit, que les réflecteurs latéraux aient une section de forme rectangulaire, hexagonale, ou autre, le réseau de diffraction présente de préférence des symétries qui sont les mêmes que celles du réflecteur. Par exemple, pour le dispositif 1R d'émission représenté sur les figures 1 à 3, le réflecteur latéral, de section rectangulaire, est invariant par symétrie par rapport au plan de la figure 1, et par symétrie rapport à un deuxième plan qui est vertical et perpendiculaire au plan de la figure 1. Et il en est de même du réseau 30R (voir la figure 3). On notera que le réseau 30R, triangulaire, pourrait aussi être employé avec un réflecteur latéral de section hexagonale ou triangulaire, le réflecteur et le réseau présentant alors tous deux les mêmes symétries. Ces deux derniers cas permettent avantageusement, pour l'ensemble du réseau, d'obtenir le même nombre d'éléments diffractifs selon les directions de hautes symétries du réseau (tous les 60° pour la maille triangulaire), puisque (un réseau ou cristal photonique de maille triangulaire ou hexagonale s'inscrit parfaitement sur une face supérieure hexagonale).

Le fait que le réseau et le réflecteur latéral présentent tous deux les mêmes symétries est intéressant, car la ou les réflexions sur la surface réfléchissante du réflecteur ont alors pour effet, d'un point de vue optique, de démultiplier à l'identique le réseau de diffraction (autrement formulé, ajouter le reflet du réseau au réseau lui-même revient alors à obtenir un réseau effectif *de même structure,* mais plus étendu).

Ici, chacun des réflecteurs latéraux 40R et 40G s'étend non seulement en vis-à-vis de la surface latérale 24R, 24G de la couche de conversion correspondante, mais, verticalement, vers le bas, jusqu'à la couche supérieure 18 de la LED 10R, 10G qui produit le premier rayonnement (rayonnement «bleu», ici). Le réflecteur latéral 40R et 40G s'étend ainsi axialement depuis la couche supérieure 18 de la LED 10R, 10G, jusqu'à la couche de conversion 20R, 20G, et même ici, sur toute la hauteur de l'empilement de conversion 90 (jusqu'à une face supérieure 101 du pixel, qui constitue par exemple une face supérieure libre).

Le premier dispositif d'émission 1B, qui est dépourvu de couche de conversion, est pourvu lui aussi d'un réflecteur latéral 40B. Ce réflecteur 40B s'étend axialement, depuis la couche supérieure 18 de la LED 10B de ce dispositif, jusqu'à la même hauteur que les couches de conversion 20R, 20G, et même jusqu'à la face supérieure 101 du pixel 100. La zone de l'espace entourée par ce réflecteur 40B s'étend au-dessus de la LED 10B, au droit de celle-ci, et coïncide avec la surface de la face supérieure 18 de la LED 10B. Cette zone est remplie par le matériau de remplissage 50.

Les différents réflecteurs latéraux 40R, 40G et 40B sont réalisés ici :

- en pratiquant des tranchées sensiblement verticales dans l'empilement de conversion 90, plus précisément dans le matériau de remplissage 50 qui sert de support et de protection pour les couches de conversion 20R, 20G, et

- en remplissant ces tranchées avec un métal, par exemple de l'or Au, de l'argent Ag, du titane Ti, de l'aluminium Al ou tout autre métal apte à réfléchir la lumière visible.

Les tranchées pratiquées ainsi dans l'empilement de conversion 90 s'étendent au droit des parois latérales 16 métalliques, décrites plus haut, qui séparent les différentes LEDs 10R, 10G, 10B les unes des autres.

Vu le mode de fabrication des réflecteurs latéraux 40R, 40G et 40B, certaines parties de ces réflecteurs sont communes à plusieurs réflecteurs différents. Les réflecteurs 40R et 40G comprennent par exemple une paroi métallique qui est commune à ces deux réflecteurs, à la frontière entre le deuxième et le troisième dispositifs d'émission 1R et 1G (figure 1).

Les parois métalliques qui forment les réflecteurs latéraux 40R, 40G et 40B ont de préférence une épaisseur supérieure ou égale à 0,1 micron, afin d'être les plus réfléchissantes possibles et pour éviter un passage de lumière entre deux dispositifs d'émission adjacents.

Le réflecteur latéral 40R forme, avec les parois latérales 16 métalliques qui entourent la couche active 15 de la LED 10R, un système de confinement latéral pour le premier rayonnement émis par cette LED 10R. Ce système de confinement, qui ici comprend aussi les éléments de reprise de contact 17, s'étend axialement depuis la couche active 15 de la LED 10R jusqu'à la couche de conversion 20R (et même au-delà, vue l'extension verticale du réflecteur latéral 40R).

Ce système de confinement latéral guide le premier rayonnement émis par la LED 10R, depuis la couche active 15 jusqu'à la couche de conversion 20R où il est converti, évitant ainsi que ce rayonnement n'atteigne la couche de conversion 20G du troisième dispositif 1G (ce qui produirait un peu de lumière verte parasite, au lieu de produire de la lumière rouge), ou ne sorte du pixel 100 sans traverser la couche de conversion 20R. Ce confinement latéral du premier rayonnement permet donc d'améliorer la pureté des couleurs produites, et limite le crosstalk (diaphonie) entre les différents dispositifs élémentaires d'émission 1R, 1G, 1B du pixel 100. Réaliser ce confinement latéral au moyen d'un matériau métallique, réfléchissant, permet, en sortie du pixel, de délivrer une puissance lumineuse supérieure à ce qui serait obtenu avec des parois latérales absorbantes, non réfléchissantes, par exemple en résine noire absorbante.

De la même manière, le réflecteur latéral 40G du troisième dispositif 1G forme, avec les parois latérales 16 métalliques qui entourent la couche active 15 de la LED 10G correspondante, un système de confinement latéral pour le premier rayonnement, et il en est de même pour le réflecteur latéral 40B du premier dispositif 1B.

Comme on peut le voir sur la figure 1, pour les deuxième et troisième dispositifs 1R, 1G, la surface réfléchissante 41R, 41G du réflecteur latéral 40R, 40G est séparée de la surface latérale 24R, 24G de la couche de conversion correspondante par une certaine distance $d_R$, $d_G$. L'espace situé entre ces deux surfaces est rempli par le matériau de remplissage d'indice $n_2$.

Pour un dispositif optoélectronique d'émission de lumière inventif, pour un pixel inventif et pour un procédé inventif, la distance $d_R$ est ici supérieure à $\lambda_R/(n_2 \times 40)$, tandis que la distance $d_G$ est supérieure à $\lambda_G/(n_2 \times 40)$. Ecarter ainsi la couche de conversion 20R, 20G de la surface réfléchissante 41R, 41G, qui peut être métallique, permet d'éviter un couplage plasmonique vers le métal du réflecteur, couplage qui causerait des pertes de puissance (point qui a été confirmé par des simulations numériques, de type différences finies dans le domaine temporel).

Pour un dispositif optoélectronique d'émission de lumière inventif, pour un pixel inventif et pour un procédé inventif, la distance $d_R$ est par ailleurs inférieure à $\lambda_R/(n_2 \times 2)$, tandis que la distance $d_G$ est inférieure à $\lambda_G/(n_2 \times 2)$. D'un point de vue optique, cela permet d'éviter une trop grande discontinuité (c'est-à-dire un écart important par rapport au pas $p_R$, $p_G$ du réseau), entre le réseau 30R, 30G lui-même et son image par la surface réfléchissante. En d'autres termes, cela permet d'obtenir un réseau optique effectif proche d'un réseau régulier de pas $p_R$, $p_G$, sans discontinuité entre le réseau réel et sa ou ses différentes réplications par la surface réfléchissante 41R, 41G. Cela est intéressant, car l'efficacité d'extraction d'un réseau «effectif» étendu et régulier est meilleure que celle d'un réseau effectif étendu, mais avec des discontinuités entre chaque réplication du réseau initial. Pour optimiser la régularité avec laquelle le réseau est répliqué, d'un point de vue optique, la distance $d_R$ et la distance $d_G$ peuvent d'ailleurs être choisies dans des gammes de distances plus étroites que la gamme $\lambda_R/(n_2 \times 40)$ à $\lambda_R/(n_2 \times 2)$, et $\lambda_G/(n_2 \times 40)$ à $\lambda_G/(n_2 \times 2)$. Les gammes en question, déterminées par exemple par simulation numérique, peuvent par exemple être choisies de manière à ce que, pour les motifs situés sur les bords du réseau 30R, 30G, la distance effective entre le motif 31R considéré et son image par la surface réfléchissante 41R, 41G ne s'écarte pas du pas $p_R$, $p_G$ du réseau de plus de 20%. L'ajustement (lors de simulations numériques) des distances $d_R$ et $d_G$ permet ainsi, en ajustant le déphasage à la réflexion, de maximiser la puissance du rayonnement extrait (en tendant vers une réplication effective du réseau quasiment parfaite).

La figure 6 représente schématiquement et partiellement un autre mode de réalisation du deuxième dispositif d'émission, 1R'.

Le deuxième dispositif 1R' selon ce deuxième mode de réalisation est identique au deuxième dispositif 1R selon le premier mode de réalisation, qui a été décrit plus haut en référence aux figures 1 à 4, si ce n'est qu'il comprend en outre un premier et un second filtres réfléchissants multicouches 35R et 36R, situés respectivement au-dessous et au-dessus de l'empilement comprenant les couches 22R, 21R et 23R.

Le premier filtre 35R est situé entre la LED 10R et le ou les puits quantiques 21R. Il est au moins partiellement réfléchissant pour le deuxième rayonnement (rouge). Sa réflectivité, c'est-à-dire son coefficient de réflexion de la puissance lumineuse, est par exemple supérieur à 70%, voire supérieur à 90%, pour le deuxième rayonnement. Le premier filtre 35R peut être configuré par ailleurs pour avoir un coefficient de transmission élevé, par exemple supérieur à 70%, voire supérieur à 90%, à la longueur d'onde moyenne du premier rayonnement (bleu), issu de la LED 10R. Cela permet qu'une part importante du premier rayonnement atteigne le ou les puits quantiques 21R, où ce premier rayonnement est converti.

Le deuxième filtre 36R s'étend directement au-dessus de la couche supérieure 23R de la couche de conversion 20R', contre cette couche supérieure. Il est au moins partiellement réfléchissant pour le premier rayonnement. Sa réflectivité est par exemple supérieure à 70%, voire supérieure à 90%, pour le premier rayonnement. Cela évite qu'une partie du premier rayonnement, qui n'aurait pas été absorbée par la couche de conversion, ne sorte du dispositif 1R', améliorant ainsi la pureté de la couleur du rayonnement émis finalement par le dispositif 1R'. En outre, la partie du premier rayonnement qui n'aurait pas été absorbée et convertie est alors renvoyée vers la structure à puits quantiques 21R où cette partie résiduelle du premier rayonnement peut être absorbée et convertie.

Le deuxième filtre 36R peut être configuré par ailleurs pour avoir un coefficient de transmission élevé, par exemple supérieur à 70%, voire supérieur à 90%, pour le deuxième rayonnement, émis par le ou les puits quantiques 21R, facilitant ainsi l'extraction de ce rayonnement.

En variante, le deuxième filtre 36R pourrait toutefois être configuré de manière à avoir un coefficient de transmission modéré pour le deuxième rayonnement, par exemple inférieure à 60%, et un coefficient de réflexion, pour ce même rayonnement, compris par exemple entre 40 et 70 %. Dans ce cas, l'ensemble des premier et deuxième filtres 35R et 36R forme alors une cavité Fabry-Pérot. L'épaisseur optique de la couche de conversion 20R' est alors choisie de manière à ce que cette cavité soit résonnante pour la longueur d'onde moyenne $\lambda_R$ du deuxième rayonnement, en présentant un pic de transmission pour cette longueur d'onde. Cette disposition peut permettre, entre autres, d'affiner le spectre de la lumière produite, par photoluminescence, par cette couche de conversion 20R'. Le réglage de l'accord et du facteur de qualité cette cavité Fabry-Pérot permettent de définir précisément la redistribution spectrale et la largeur à mi-hauteur du rayonnement extrait.

D'une manière connue de l'état de la technique, le réglage d'une cavité est défini par le déphasage $d\Phi$ entre deux rayons sortants successifs :

$$d\Phi(\theta) = 2knl(\cos\theta)$$

où $n$ est l'indice de réfraction de la cavité ; $l$ est l'épaisseur effective de la cavité ; $\theta$ est l'angle de réfraction des rayons

et $k = 2\pi/\lambda_R$ avec $\lambda_R$ la longueur d'onde des rayons. Les rayons successifs interfèrent constructivement si leur déphasage $d\Phi$ est égal à $2\pi$ (modulo $2\pi$); et ils interfèrent destructivement si leur déphasage $d\Phi$ est égal à $\pi$ (modulo $2\pi$).

Chacun des premier et deuxième filtres 35R, 36R est par exemple un miroir de Bragg, réalisé par une combinaison de couches minces diélectriques d'épaisseur $\lambda/4n$ et de haut et bas indices (où n est l'indice optique de la couche mince considérée), par exemple de SiO2/TiO2 ou SiO2/Si3N4. Les indices optiques de ces matériaux sont, à 460 nm, respectivement de 1,464/2,7878 et 1,464/2,0751. L'épaisseur de chacun de ces miroirs de Bragg est typiquement de l'ordre du micron, voire inférieure à 1 micron. Alternativement, chacun des premier et deuxième filtres 35R, 36R réfléchissants multicouches est par exemple un empilement non-périodique de couches d'épaisseurs optimisées, permettant d'obtenir un gabarit de filtre précis.

Il est possible de réaliser la cavité Fabry-Pérot en question directement par épitaxie, ou par dépôt de couches minces successives (après épitaxie du réseau), ce qui est généralement plus simple en termes de fabrication

Pour ce mode de réalisation du deuxième dispositif 1R', le réseau de diffraction 30R', qui favorise l'extraction du deuxième rayonnement, peut être réalisé sous la forme de trous ou de piliers qui traversent les couches minces du deuxième filtre 36R, comme représenté sur la figure 6. D'autres manières de réaliser ce réseau de diffraction, avec par exemple une gravure moins profonde, en surface du deuxième filtre, sont également envisageables.

Dans une variante non représentée, le troisième dispositif d'émission pourrait lui aussi être pourvu d'un premier et d'un deuxième filtres réfléchissants multicouches, agencés de manière similaire aux premier et deuxième filtres 35R, 36R du deuxième dispositif 1R' qui ont été présentés ci-dessus.

Dans le cas du troisième dispositif d'émission, le premier filtre, qui s'interposerait alors entre la LED 10G et les puits quantiques 21G, serait configuré plus précisément pour réfléchir une partie au moins du troisième rayonnement, avec une réflectivité de plus de 70%, voire de plus de 90% pour le troisième rayonnement, par exemple.

Quant au deuxième filtre, qui s'étend au-dessus des puits quantiques 21G, il serait alors configuré pour avoir un coefficient de transmission élevé, par exemple supérieur à 70%, voire supérieur à 90%, à la longueur d'onde moyenne $\lambda_G$ du troisième rayonnement, émis par le ou les puits quantiques 21G, facilitant ainsi l'extraction de ce rayonnement. Ce deuxième filtre serait configuré par ailleurs, là aussi, de manière à avoir une réflectivité élevée (de plus de 70%, voire de plus de 90%) pour le premier rayonnement.

Le deuxième filtre pourrait toutefois être configuré aussi de manière à avoir un coefficient de transmission modéré pour le troisième rayonnement, par exemple inférieure à 60%, et un coefficient de réflexion, pour ce même rayonnement, compris par exemple entre 40 et 70 %. Dans ce cas, l'ensemble des premier et deuxième filtres formerait alors une cavité Fabry-Pérot, ayant une épaisseur optique telle que cette cavité soit résonnante pour la longueur d'onde moyenne $\lambda_G$ du troisième rayonnement, en présentant un pic de transmission pour cette longueur d'onde.

Munir la couche de conversion du troisième dispositif de ces premier et deuxième filtres multicouches (qu'ils forment une cavité Fabry-Pérot ou non) est particulièrement intéressant, car la conversion du bleu vers le vert, au moyen de puits quantiques 21G en nitrure d'indium-gallium InGaN, est moins efficace que la conversion du bleu vers le rouge. Recycler le premier rayonnement, bleu, non converti lors d'une première traversée de la couche de conversion, au moyen du deuxième filtre, est donc encore plus intéressant pour le troisième dispositif que pour le deuxième dispositif (puisque ce recyclage augmente l'efficacité de conversion).

Comme on peut le voir sur la figure 1, les couches de conversion 20R, 20G respectives des deuxième et troisième dispositifs 1R et 1G sont décalées verticalement l'une par rapport à l'autre. Dans une direction perpendiculaire au plan du substrat 81, elles occupent ainsi des positions différentes. Ce décalage vertical entre les couches de conversion 20R, 20G résulte du procédé de fabrication du pixel 100.

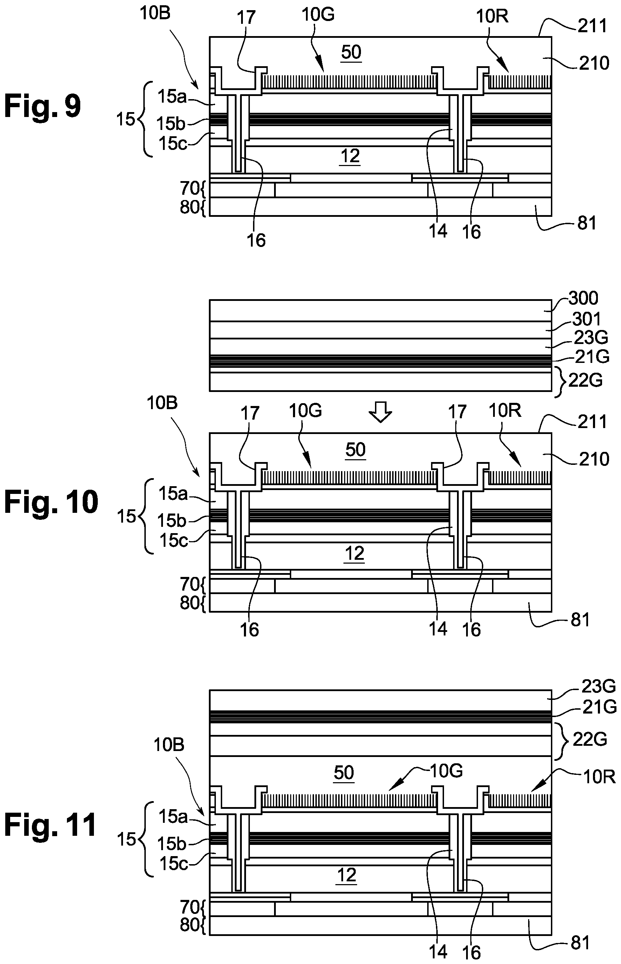

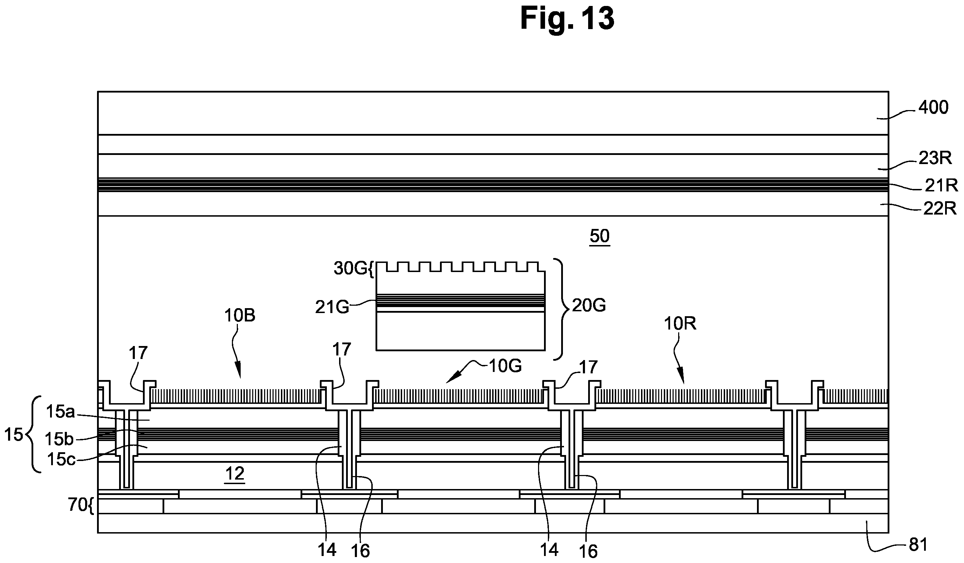

En effet, au cours de ce procédé, la couche de conversion 20G est tout d'abord réalisée sur un substrat 300, différent du substrat 81 sur lequel sont réalisés les LEDs 10R, 10G, 10B pompées électriquement. La couche de conversion 20G est ensuite reportée sur la structure de LEDs 10R, 10G, 10B (figure 10). Ensuite, de la même manière, la couche de conversion 20R, initialement réalisée sur un autre substrat 400, est reportée sur le pixel 100 (figure 13), ce qui explique la structure en couches successives, et en quelque sorte en marches d'escalier de l'empilement de conversion 90.

Le procédé de fabrication d'un pixel 100 est maintenant décrit plus en détai Le procédé du pixel 100 est inventif, quand il comprend toutes les caractéristiques de la revendication 14.

Comme on peut le voir sur la figure 7, ce procédé comprend les étapes principales suivantes :

- Etape S1 : réalisation de la structure de LEDs 10R, 10G, 10B pompées électriquement, puis
- Etape S2 : réalisation de la couche de conversion 20G du troisième dispositif 1G, puis
- Etape S3 : réalisation de la couche de conversion 20R du deuxième dispositif 1R, puis
- Etape S4 : réalisation des réflecteurs latéraux 40R, 40G, 40B.

L'étape S1 comporte tout d'abord une étape S10 de réalisation d'une structure de LEDs 10R, 10G, 10B telle que décrite précédemment, qui comporte ici la couche active 15, agencée sur l'empilement d'interconnexion 70, lui-même agencé sur le circuit intégré de contrôle 80. Ce circuit est réalisé sur et/ou dans le substrat 81, typiquement en silicium, appelé premier substrat dans la suite. De manière facultative, l'étape S10 comprend la réalisation de la couche texturée 18 telle que décrite précédemment.

Le procédé comporte ensuite une étape S11 d'encapsulation et planarisation. Cette étape comprend le dépôt, typiquement par dépôt conforme, d'une couche d'isolant 210, formée du matériau de remplissage 50 (typiquement du $SiO_2$), soit sur la couche texturée 18, soit directement sur le dessus de la couche active 15. Le procédé comporte ensuite une étape de planarisation, typiquement par polissage mécano-chimique CMP (de l'anglais « chemical-mechanical polishing »), de la couche d'isolant 210. Cette dernière étape permet d'obtenir une première surface de contact 211, particulièrement lisse et plane, bien adaptée pour réaliser une adhérence moléculaire entre cette surface de contact et une autre structure. La figure 9 montre le résultat obtenu à l'issue de la planarisation de la couche d'isolant 210.

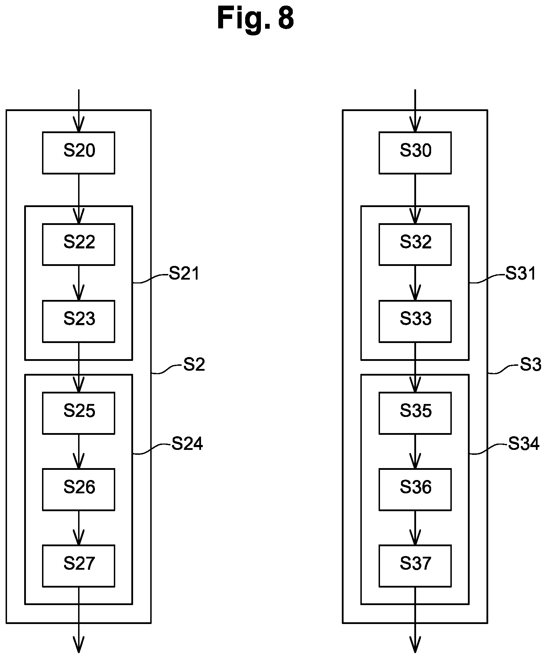

Comme on peut le voir sur la figure 8, l'étape S2 de réalisation de la couche de conversion 20G comprend les étapes suivantes :

- S20 : réalisation, sur un deuxième substrat 300, d'un empilement qui comprend deux couches de revêtement 22G et 23G (ou «cladding» en anglais) ainsi qu'un empilement de puits quantiques planaires 21G enserré (en quelques sorte pris en sandwich) entre ces deux couches de revêtement (voir la figure 10),

- S21 : report de cet empilement sur la structure de LEDs 10R, 10G, 10B et retrait du deuxième substrat 300 (figure 11),

- S24 : mise en forme et encapsulation de la couche de conversion 20G.

Le deuxième substrat 300 sur lequel est réalisé l'empilement, qui, après gravure, formera la couche de conversion 20G, est par exemple un substrat en silicium ou en saphir. Une couche tampon 301 peut être déposée sur ce substrat, avant de réaliser l'empilement en question.

L'étape S21 comprend une étape de report S22, puis une étape de retrait du substrat S23.

Lors de l'étape de report S22, la face libre de la couche 22G est mise en contact avec la première surface de contact 211. L'empilement 22G, 21G, 23G est alors fixé sur cette surface directement par adhérence moléculaire, c'est-à-dire sans utiliser de matériau de collage supplémentaire. En variante l'empilement 22G, 21G, 23G pourrait toutefois être fixé sur la première surface de contact 211 par collage.

Lors de l'étape S23, le retrait du deuxième substrat 300 est par exemple un retrait par laser (ou «Laser Lift Off» en anglais), lorsque le deuxième substrat est en saphir. Lorsque le deuxième substrat est en silicium, il peut par exemple être retiré par amincissement.

La figure 11 montre le pixel 100, à un stade intermédiaire de sa fabrication, juste après l'étape de retrait S23.

L'étape suivante S24, de mise en forme et encapsulation de la couche de conversion 20G, comprend les étapes suivantes :

- S25 : réalisation du réseau de diffraction 30G,

- S26 : gravure de l'empilement de couches 22G, 21G, 23G, pour délimiter latéralement la couche de conversion 20G,

- S27 : encapsulation et planarisation.

Lors de l'étape S25, le réseau de diffraction 30G est gravé sur la face supérieure libre de la couche 23G. Cette gravure comporte typiquement le dépôt d'un masque suivi d'une lithogravure de type DUV (de l'anglais « deep UV »). Alternativement, cette gravure peut être une gravure ionique réactive RIE (de l'anglais « Reactive-Ion Etching »).

L'étape S26 peut elle aussi comporter le dépôt d'un masque suivi d'une lithogravure de type DUV, ou être réalisée par gravure ionique réactive RIE. A l'issu de cette étape, le couche de conversion 20G forme un îlot, ou mesa, délimité latéralement par la surface latérale 24G mentionnée précédemment.

Lors de l'étape S27, du matériau de remplissage 50 est déposé autour et sur l'ilot que forme la couche de conversion 20G. La surface supérieure de cette couche de remplissage est ensuite polie, typiquement par polissage mécano-chimique CMP (de l'anglais « chemical-mechanical polishing »), pour d'obtenir une deuxième surface de contact 212, particulièrement lisse et plane.

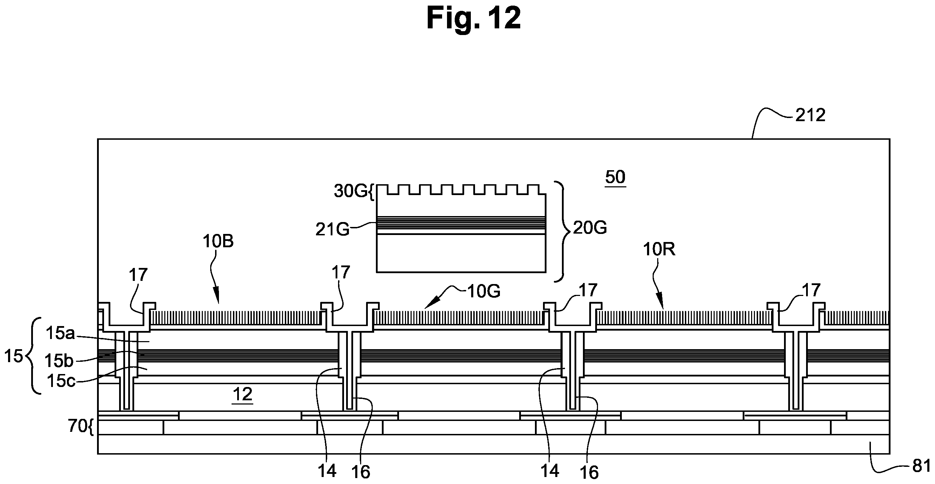

La figure 12 montre le pixel, en cours de fabrication, une fois l'étape S2 exécutée.

L'étape S3 de réalisation de la couche de conversion 20R comprend des étapes S30 à S37 similaires, respectivement, aux étapes S20 à S27 qui viennent d'être décrite.

Lors de l'étape S30, l'empilement de couches 22R, 21R, 23R, qui, après gravure, formera la couche de conversion 20R, est réalisé sur un troisième substrat 400, formé ici en arsenure de gallium GaAs.

L'empilement de couches 22R, 21R, 23R est reporté et fixé (par exemple par adhérence moléculaire) sur la deuxième surface de contact 212, lors de l'étape S32. La figure 13 montre le pixel, en cours de fabrication, juste après cette étape de report.

Lors de l'étape suivante de retrait, S33, le troisième substrat 400 peut être retiré par attaque chimique sélective, par de l'acide sulfurique $H_2SO_4$, de l'acide phosphorique $H_3PO_4$, ou de l'ammoniac $NH_{3(aq)}$. En effet, ces substances attaquent plus fortement l'arsenure de gallium AsGa que le Phosphorure d'Aluminium d'indium AlInGaP ou le Phosphorure d'Indium-Gallium InGaP.

L'étape S35 de réalisation du réseau de diffraction 30R peut être réalisée, comme l'étape S25, par dépôt d'un masque suivi d'une lithogravure de type DUV, ou par gravure ionique réactive RIE.

L'étape S36 de gravure latérale des couches 22R, 21R, 23R, et l'étape S37 d'encapsulation de la couche de conversion 20R sont identiques, respectivement, aux étapes S26 et S27 décrites plus haut.

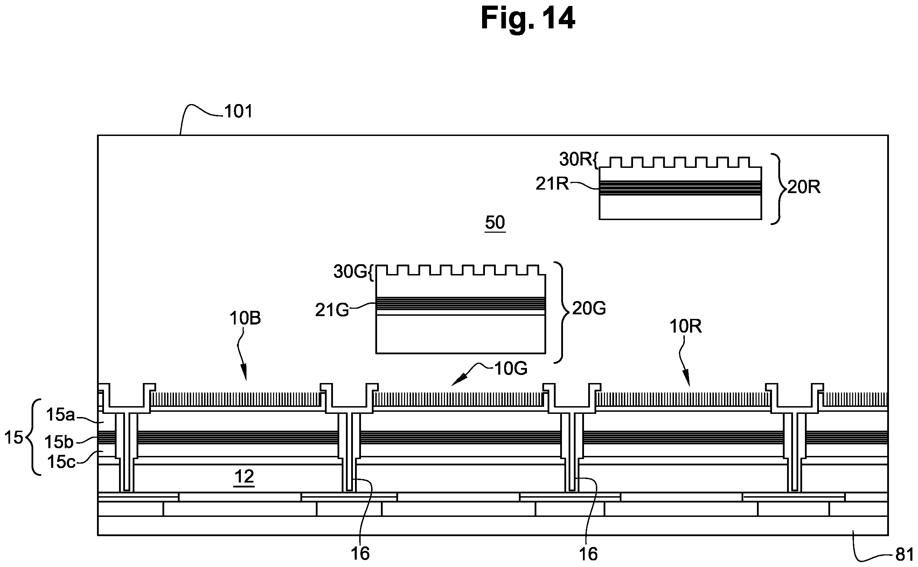

La figure 14 montre le pixel 100, en cours de fabrication, juste après l'étape S3.

L'étape S4 de réalisation des réflecteurs latéraux 40R, 40G, 40B comprend une étape S40 d'ouverture des tranchées qui, dans l'empilement de conversion 90, délimitent les différents dispositifs d'émission 1R, 1G, 1B. Ces tranchées peuvent être réalisées par gravure ionique réactive RIE profonde. Chaque tranchée est alignée ici avec l'un des éléments de reprise de contact 17.

Le procédé comporte ensuite une étape S41 de dépôt de métal dans les tranchées, par exemple par dépôt électrochimique ECD (de l'anglais « electrochemical déposition »), suivie d'une étape de planarisation, par exemple par CMP, afin d'éviter tout court-circuit. Le procédé peut comporter ensuite une étape de réalisation des contacts Ch (plot de contact commun aux cathodes) et Cb (plot de contact commun aux anodes, dans d'autres variantes), aux extrémités des lignes de cathode et d'anode, typiquement au moyen du dépôt d'un métal suivi d'une gravure. La figure 1 montre le résultat obtenu à l'issue de l'étape S4.

Remplir ainsi les tranchées de métal est plus difficile et plus onéreux que de d'isoler optiquement les dispositifs 1R, 1G, 1B les uns des autres grâce à des parois en résine absorbante noire (notamment car le métal doit être quasiment sous forme liquide pour remplir les tranchées en question). Cette réalisation nécessite en particulier de disposer à la fois de moyens de fabrication propres à la nano-photonique (pour réaliser les puits quantiques et les cristaux photoniques), et de moyens de fabrications propres à la micro-électronique sur silicium, notamment pour réaliser le dépôt électrochimique ECD.

Dans un autre mode de réalisation, le procédé de fabrication du pixel pourrait comprendre aussi des étapes de réalisation des premier et deuxième filtres 35R, 36R réfléchissants multicouches qui, de manière optionnelle, enserrent la partie active de la couche de conversion 20R' du deuxième dispositif 1R' d'émission et/ou du troisième dispositif d'émission.

Dans ce cas, les filtres 35R, 36R réfléchissants multicouches du deuxième dispositif 1R' peuvent être réalisés lors de la fabrication, sur le troisième substrat 400, de l'empilement de couches 22R, 21R, 23R (donc lors de l'étape S30, avant l'étape S31 de report et de retrait du troisième substrat 400). Dans ce cas, le deuxième filtre 36R est réalisé par dépôt sur le troisième substrat 400, avant la réalisation de l'empilement de couches 22R, 21R, 23R. Et le premier filtre 35R est réalisé par dépôt sur la couche 22R, une fois celle-ci réalisée. L'ensemble les filtres 35R et 36R, et l'empilement de couches 22R, 21R, 23R pris en sandwich entre ces filtres est ensuite reporté en bloc sur la deuxième surface de contact 212.

De la même manière, lorsque le troisième dispositif d'émission est muni des premier et deuxième filtres réfléchissants décrits plus haut, ces filtres peuvent être réalisés lors de la fabrication, sur le deuxième substrat 300, de l'empilement de couches 22G, 21G, 23G (donc lors de l'étape S20, avant l'étape S21).

En variante, les premier et deuxième filtres réfléchissants 35R, 36R pourraient néanmoins être réalisés, par dépôt, directement au-dessus de la LED 10R, , plutôt que d'être réalisés sur le troisième substrat 400, puis reportés. Dans ce cas, le premier filtre 35R serait fabriqué en réalisant des dépôts sur la deuxième surface de contact 221, avant que l'empilement de couches 22R, 21R, 23R ne soit reporté sur ce filtre 35R. Et le deuxième filtre serait alors réalisé, par dépôt sur la couche 23R, juste après l'étape S31 de report et de retrait, et avant l'étape S24 de mise en forme et encapsulation de la couche de conversion 20R'.

De la même manière, les premier et deuxième filtres réfléchissants du troisième dispositif pourraient être réalisés, par dépôt, directement au-dessus de la LED 10G, plutôt que d'être réalisés sur le deuxième substrat puis reportés.

Différents modes de réalisation et variantes d'un procédé de fabrication du pixel 100 ont été décrits ci-dessus. Mais l'on comprend bien que l'invention concerne aussi un procédé de fabrication d'un dispositif d'émission de lumière, tel que le deuxième dispositif 1R, 1R' ou le troisième dispositif 1G, considéré seul, en tant que tel. Un tel dispositif pourra être fabriqué, comme expliqué ci-dessus, par report sur un premier substrat, d'un empilement comprenant les puits quantiques de conversion, empilement réalisé préalablement sur un autre substrat.

L'invention concerne aussi un procédé de fabrication de l'afficheur mentionné plus haut, qui comporte une matrice de pixels en couleurs tels que le pixel 100. Cet afficheur peut par exemple être réalisé au moyen d'un procédé similaire au procédé de la figure 7 mais dans lequel :

- à l'étape S10, plusieurs triplets de LEDs 10R, 10G, 10B pompées électriquement sont réalisés sur le premier substrat 81 (autant de triplets que ce que ladite matrice compte de pixels),

- à l'étape S26, plusieurs ilots (autant d'ilots que de pixels), formant chacun une couche de conversion 20G pour un dispositif d'émission dans le vert, sont gravés, par exemple simultanément, dans l'empilement de couches 22G, 21G, 23G (initialement très étendu latéralement) qui avait été reporté précédemment sur la première surface de contact 211,

- de même, à l'étape S36, plusieurs ilots (autant d'ilots que de pixels), formant chacun une couche de conversion 20R pour un dispositif d'émission dans le rouge, sont gravés, par exemple simultanément, dans l'empilement de couches 22R, 21R, 23R (initialement très étendu latéralement) qui avait été reporté précédemment sur la deuxième surface de contact 212, et

- à l'étape S4, on réalise des tranchées qui, dans l'empilement de conversion 90, délimitent latéralement chaque dispositif d'émission individuel 1R, 1G, 1B de la matrice de pixels, et on remplit ces tranchées de métal.

On notera que différentes variantes peuvent être apportées aux procédés qui viennent d'être présentés, en plus de celles déjà mentionnées plus haut. Ainsi, par exemple, on pourrait prévoir d'exécuter l'étape S3 avant l'étape S2.

## Revendications

1. Dispositif (1R ; 1R', 1G) optoélectronique d'émission de lumière comprenant :

   - une diode électroluminescente (10R, 10G) configurée pour émettre un premier rayonnement, et
   - une couche de conversion (20R ; 20R', 20G) qui s'étend au-dessus de la diode électroluminescente (10R, 10G) et qui est configurée pour convertir une partie au moins du premier rayonnement en un deuxième rayonnement, par photoluminescence, la couche de conversion étant délimitée latéralement par une surface latérale (24R, 24G), la couche de conversion (20R ; 20R', 20G) comprenant au moins un puit quantique (21R, 21G) planaire configuré pour émettre le deuxième rayonnement,
   - un réseau de diffraction (30R ; 30R', 30G), configuré pour extraire une partie au moins du deuxième rayonnement de la couche de conversion, le réseau de diffraction étant gravé sur une face supérieure (25R, 25G) de la couche de conversion,
   - le dispositif comprenant en outre un réflecteur (40R, 40G) latéral ayant une surface réfléchissante (41R, 41G) qui s'étend transversalement par rapport à la couche de conversion (20R ; 20R', 20G), en face d'une partie au moins de la surface latérale (24R, 24G) de la couche de conversion, la surface réfléchissante (41R, 41G) du réflecteur et la surface latérale (24R, 24G) de la couche de conversion (20R ; 20R', 20G) étant séparées l'une de l'autre par un matériau (50) ayant un indice optique $n_2$, **caractérisé en ce qu'**
   une distance ($d_R$, $d_G$) séparant la surface réfléchissante (41R, 41G) du réflecteur de la surface latérale (24R, 24G) de la couche de conversion est comprise entre $\lambda/(n_2 \times 40)$ et $\lambda/(n_2 \times 2)$ où $\lambda$, est la longueur d'onde moyenne du deuxième rayonnement.

2. Dispositif (1R ; 1R', 1G) selon la revendication précédente, dans lequel la surface réfléchissante (41R, 41G) du réflecteur s'étend autour de la couche de conversion (20R ; 20R', 20G), sur la majeure partie du pourtour de la couche de conversion.

3. Dispositif (1R; 1R', 1G) selon l'une quelconque des revendications précédentes, dans lequel la surface réfléchissante (41R, 41G) du réflecteur comprend au moins une première face réfléchissante (46R, 46G) et une deuxième face réfléchissante (47R, 47G), chaque face réfléchissante (46R, 47R, 46G, 47G) s'étendant transversalement par rapport à la couche de conversion (20R ; 20R', 20G), face à une partie (26R, 27R, 26G, 27G) de la surface latérale (24R, 24G) de la couche de conversion, la deuxième face réfléchissante (47R, 47G) étant située à l'opposé de la première face réfléchissante (46R, 46G) par rapport à la couche de conversion (20R ; 20R', 20G), les première et deuxième faces réfléchissantes étant sensiblement parallèles entre elles.

4. Dispositif (1R; 1R', 1G) selon l'une quelconque des revendications précédentes, dans lequel le réflecteur (40R, 40G) est formé, au moins superficiellement, d'un métal.

5. Dispositif (1R; 1R', 1G) selon l'une quelconque des revendications précédentes dans lequel la face supérieure (25R, 25G) de la couche de conversion (20R ; 20R', 20G) s'étend sur une aire inférieure à 1000 microns carrés, voire inférieure à 100 microns carrés.

6. Dispositif (1R; 1R', 1G) selon l'une quelconque des revendications précédentes dans lequel la diode électroluminescente (10R, 10G) comprend une couche active (15) d'où est émis le premier rayonnement, le dispositif (1R ; 1R', 1G) comprenant en outre un système de confinement latéral qui inclut ledit réflecteur (40R, 40G) latéral, qui s'étend axialement depuis la couche active (15) jusqu'à la couche de conversion (20R ; 20R', 20G) et qui est configuré pour confiner latéralement le premier rayonnement.

7. Dispositif (1R') selon l'une quelconque des revendications précédentes, comprenant un premier filtre (35R) réfléchissant multicouche qui s'étend entre la diode électroluminescente (10R) et le puit quantique (21R) planaire et qui est au moins partiellement réfléchissant pour le deuxième rayonnement.

8. Dispositif (1R') selon l'une quelconque des revendications précédentes, comprenant un deuxième filtre (36R) réfléchissant multicouche qui s'étend au-dessus du puit quantique (21R) planaire, au moins partiellement réfléchissant pour le premier rayonnement.

9. Pixel (100) comprenant :

- un dispositif (1R; 1R') optoélectronique selon l'une quelconque des revendications précédentes, et
- un dispositif optoélectronique d'émission de lumière supplémentaire (1G) comprenant :

o une diode électroluminescente supplémentaire (10G), configurée pour émettre ledit premier rayonnement,
o une couche de conversion supplémentaire (20G) qui s'étend au-dessus de la diode électroluminescente supplémentaire (10G) et qui est configurée pour convertir une partie au moins du premier rayonnement en un troisième rayonnement, par photoluminescence, la couche de conversion supplémentaire (20G) étant délimitée latéralement une surface latérale (24G), la couche de conversion supplémentaire comprenant au moins un puit quantique (21G) planaire supplémentaire configuré pour émettre le troisième rayonnement, un réseau de diffraction supplémentaire (30G), configuré pour extraire une partie au moins du troisième rayonnement de la couche de conversion supplémentaire (20G), étant gravé sur une face supérieure (25G) de la couche de conversion supplémentaire, et
o un réflecteur latéral supplémentaire (40G) ayant une surface réfléchissante (41G) dont une partie au moins s'étend transversalement par rapport à la couche de conversion supplémentaire (20G), face à la surface latérale (24G) de la couche de conversion supplémentaire.

10. Pixel (100) selon la revendication précédente comprenant encore un autre dispositif (1B) optoélectronique d'émission de lumière qui comporte une autre diode électroluminescente (10B) configurée pour émettre ledit premier rayonnement et qui est :

- soit dépourvu de couche de conversion,
- soit muni d'une couche de conversion additionnelle, configurée pour convertir une partie au moins du premier rayonnement en un quatrième rayonnement différent des deuxième et troisième rayonnements.

11. Afficheur comprenant une matrice de pixels (100) conformes à la revendication 9 ou 10.

12. Procédé de fabrication d'un dispositif (1G, 1R; 1R') optoélectronique d'émission de lumière, comprenant les étapes suivantes :

- (S10) réalisation d'une diode électroluminescente (10G, 10R) configurée pour émettre un premier rayonnement,
- (S2, S3) réalisation d'une couche de conversion (20G, 20R ; 20R'), qui s'étend au-dessus de la diode électroluminescente (10G, 10R) et qui est configurée pour convertir une partie au moins du premier rayonnement en un deuxième rayonnement, par photoluminescence, la couche de conversion étant délimitée latéralement par une surface latérale (24G, 24R),
- l'étape (S2, S3) de réalisation de la couche de conversion (20G, 20R ; 20R') comprenant une étape (S20, S30) de réalisation d'un puit quantique (21G, 21R) planaire configuré pour émettre le deuxième rayonnement, le procédé comprenant en outre les étape suivantes :

∘ (S25, S35) gravure d'un réseau de diffraction (30G, 30R) sur une face supérieure (25G, 25R) de la couche de conversion, le réseau de diffraction étant configuré pour extraire une partie au moins du deuxième rayonnement de la couche de conversion (20G, 20R ; 20R'), et

∘ (S4) réalisation d'un réflecteur latéral (40G, 40R) ayant une surface réfléchissante (41G, 41R) qui s'étend transversalement par rapport à la couche de conversion (20G, 20R ; 20R'), en face d'une partie au moins de la surface latérale (24G, 24R) de la couche de conversion, la surface réfléchissante (41R, 41G) du réflecteur et la surface latérale (24R, 24G) de la couche de conversion (20R ; 20R', 20G) étant séparées l'une de l'autre par un matériau (50) ayant un indice optique $n_2$, et dans lequel une distance ($d_R$, $d_G$) séparant la surface réfléchissante (41R, 41G) du réflecteur de la surface latérale (24R, 24G) de la couche de conversion est comprise entre $\lambda/(n_2 \times 40)$ et $\lambda/(n_2 \times 2)$ où $\lambda$ est la longueur d'onde moyenne du deuxième rayonnement.

**13.** Procédé selon la revendication précédente, dans lequel la diode électroluminescente (10G, 10R) est réalisée sur un premier substrat (81), le procédé comprenant en outre une encapsulation de la diode électroluminescente et une planarisation (S11) d'une surface de contact (211, 212) située au-dessus de la diode électroluminescente, et dans lequel l'étape (S2, S3) de réalisation de la couche de conversion (20G, 20R ; 20R') comprend les étapes suivantes :

- (S20, S30) sur un deuxième substrat (300, 400), réalisation d'un empilement comprenant ledit puit quantique (21G, 21R) planaire,
- (S22, S32) placer ledit empilement sur ladite surface de contact (211, 212) au contact de ladite surface de contact, et fixer ledit empilement à la surface de contact (211, 212), et
- (S22, S32) retirer le deuxième substrat (300, 400).

**14.** Procédé de fabrication d'un pixel (100), comprenant les étapes suivantes :

- (S10) réalisation d'une première, deuxième et troisième diodes électroluminescentes (10B, 10R, 10G), configurées chacune pour émettre un premier rayonnement,
- (S2) réalisation d'une couche de conversion (20G), qui s'étend au-dessus de la troisième diode électroluminescente (10G) et qui est configurée pour convertir une partie au moins du premier rayonnement en un troisième rayonnement, par photoluminescence, la couche de conversion (20G) étant délimitée latéralement par une surface latérale (24G), ladite étape de réalisation comprenant :

∘ une étape (S20) de réalisation d'au moins un puit quantique (21G) planaire configuré pour émettre le troisième rayonnement, et

∘ une étape (S25) de gravure d'un réseau de diffraction (30G) sur une face supérieure (25G) de la couche de conversion (20G), le réseau de diffraction étant configuré pour extraire une partie au moins du troisième rayonnement de la couche de conversion,

- (S3) réalisation d'une couche de conversion (20R), qui s'étend au-dessus de la deuxième diode électroluminescente (1R) et qui est configurée pour convertir une partie au moins du premier rayonnement en un deuxième rayonnement, par photoluminescence, la couche de conversion (20R) étant délimitée latéralement par une surface latérale (24R), ladite étape de réalisation comprenant :

∘ une étape (S30) de réalisation d'au moins un puit quantique (21R) planaire configuré pour émettre le deuxième rayonnement, et

∘ une étape (S35) de gravure d'un réseau de diffraction (30R) sur une face supérieure (25R) de la couche de conversion (20R), le réseau de diffraction étant configuré pour extraire une partie au moins du deuxième rayonnement de la couche de conversion (20R),

- (S4) pour chaque couche de conversion (20R, 20G), réalisation d'un réflecteur (40R, 40G) latéral ayant une surface réfléchissante (41R, 41G) qui s'étend transversalement par rapport à la couche de conversion considérée (20R, 20G), en face d'une partie au moins de la surface latérale (24R, 24G) de cette couche de conversion, la surface réfléchissante (41R, 41G) du réflecteur et la surface latérale (24R, 24G) de la couche de conversion (20R ; 20R', 20G) considérée étant séparées l'une de l'autre par un matériau (50) ayant un indice optique $n_2$, et dans lequel une distance ($d_R$, $d_G$) séparant la surface réfléchissante (41R, 41G) du réflecteur de la surface latérale (24R, 24G) de la couche de conversion considérée est comprise entre $\lambda/(n_2 \times 40)$ et $\lambda/(n_2 \times 2)$ où $\lambda$, est la longueur d'onde moyenne du deuxième rayonnement, ou, respectivement du troisième rayonnement.

**Patentansprüche**

1. Optoelektronische lichtemittierende Vorrichtung (1R; 1R', 1G), die Folgendes umfasst:

   - eine lichtemittierende Diode (10R, 10G), die so konfiguriert ist, dass sie eine erste Strahlung aussendet, und
   - eine Umwandlungsschicht (20R; 20R', 20G), die sich über der lichtemittierenden Diode (10R, 10G) erstreckt und so konfiguriert ist, dass sie zumindest einen Teil der ersten Strahlung durch Photolumineszenz in eine zweite Strahlung umwandelt, wobei die Umwandlungsschicht seitlich durch eine Seitenfläche (24R, 24G) begrenzt ist, wobei die Umwandlungsschicht (20R; 20R', 20G) mindestens einen planaren Quantentopf (21R, 21G) umfasst, der so konfiguriert ist, dass er die zweite Strahlung emittiert,
   - ein Beugungsgitter (30R; 30R', 30G), das so konfiguriert ist, dass es zumindest einen Teil der zweiten Strahlung aus der Umwandlungsschicht extrahiert, wobei das Beugungsgitter auf eine Oberseite (25R, 25G) der Umwandlungsschicht geätzt ist,
   - wobei die Vorrichtung ferner einen seitlichen Reflektor (40R, 40G) mit einer reflektierenden Oberfläche (41R, 41G) umfasst, die sich quer zu der Umwandlungsschicht (20R; 20R', 20G) erstreckt und zumindest einem Teil der Seitenfläche (24R, 24G) der Umwandlungsschicht gegenüberliegt, wobei die reflektierende Oberfläche (41R, 41G) des Reflektors und die Seitenfläche (24R, 24G) der Umwandlungsschicht (20R; 20R', 20G) durch ein Material (50) mit einem optischen Index $n_2$ voneinander getrennt sind, **dadurch gekennzeichnet, dass** ein Abstand ($d_R$, $d_G$), der die reflektierende Oberfläche (41R; 41G) des Reflektors von der Seitenfläche (24R, 24G) der Konversionsschicht trennt, zwischen $\lambda/(n_2\times40)$ und $\lambda/(n_2\times2)$ liegt, wobei $\lambda$ die mittlere Wellenlänge der zweiten Strahlung ist.

2. Vorrichtung (1R; 1R', 1G) nach dem vorhergehenden Anspruch, **dadurch gekennzeichnet, dass** sich die reflektierende Oberfläche (41R, 41G) des Reflektors um die Umwandlungsschicht (20R; 20R', 20G) herum über den größten Teil des Umfangs der Umwandlungsschicht erstreckt.

3. Vorrichtung (1R; 1R', 1G) nach einem der vorhergehenden Ansprüche, **dadurch gekennzeichnet, dass** die reflektierende Oberfläche (41R, 41G) des Reflektors mindestens eine erste reflektierende Fläche (46R, 46G) und eine zweite reflektierende Fläche (47R, 47G) umfasst, wobei sich jede reflektierende Fläche (46R, 47R, 46G, 47G) quer zur Umwandlungsschicht (20R; 20R', 20G) gegenüber einem Teil (26R, 27R, 26G, 27G) der Seitenfläche (24R, 24G) der Umwandlungsschicht erstreckt, wobei die zweite reflektierende Fläche (47R, 47G) in Bezug auf die Umwandlungsschicht (20R; 20R', 20G) gegenüber der ersten reflektierenden Fläche (46R, 46G) angeordnet ist, wobei die erste und die zweite reflektierende Fläche im Wesentlichen parallel zueinander angeordnet sind.

4. Vorrichtung (1R; 1R', 1G) nach einem der vorhergehenden Ansprüche, **dadurch gekennzeichnet, dass** der Reflektor (40R, 40G) zumindest an der Oberfläche aus einem Metall gebildet ist.

5. Vorrichtung (1R; 1R', 1G) nach einem der vorhergehenden Ansprüche, **dadurch gekennzeichnet, dass** sich die Oberseite (25R, 25G) der Umwandlungsschicht (20R; 20R', 20G) über eine Fläche von weniger als 1000 Quadratmikrometern oder sogar weniger als 100 Quadratmikrometern erstreckt.

6. Vorrichtung (1R; 1R', 1G) nach einem der vorhergehenden Ansprüche, **dadurch gekennzeichnet, dass** die lichtemittierende Diode (10R, 10G) eine aktive Schicht (15) umfasst, von der die erste Strahlung emittiert wird, wobei die Vorrichtung (1R; 1R', 1G) ferner ein System zur seitlichen Begrenzung umfasst, das den seitlichen Reflektor (40R, 40G) umfasst, der sich axial von der aktiven Schicht (15) zur Umwandlungsschicht (20R; 20R', 20G) erstreckt und so konfiguriert ist, dass er die erste Strahlung seitlich begrenzt.

7. Vorrichtung (1R') nach einem der vorhergehenden Ansprüche, **dadurch gekennzeichnet, dass** sie einen ersten mehrschichtigen reflektierenden Filter (35R) umfasst, der sich zwischen der lichtemittierenden Diode (10R) und dem planaren Quantentopf (21R) erstreckt und der zumindest teilweise für die zweite Strahlung reflektierend ist.

8. Vorrichtung (1R') nach einem der vorhergehenden Ansprüche, **dadurch gekennzeichnet, dass** sie einen zweiten mehrschichtigen reflektierenden Filter (36R) umfasst, der sich über dem planaren Quantentopf (21R) erstreckt, der zumindest teilweise für die erste Strahlung reflektierend ist.

9. Pixel (100), das Folgendes umfasst:

   - eine optoelektronische Vorrichtung (1R; 1R') nach einem der vorhergehenden Ansprüche, und

- eine zusätzliche lichtemittierende optoelektronische Vorrichtung (1G), die Folgendes umfasst:

o eine zusätzliche lichtemittierende Diode (10G), die so konfiguriert ist, dass sie die erste Strahlung aussendet,

o eine zusätzliche Umwandlungsschicht (20G), die sich über der zusätzlichen lichtemittierenden Diode (10G) erstreckt und so konfiguriert ist, dass sie zumindest einen Teil der ersten Strahlung durch Photolumineszenz in eine dritte Strahlung umwandelt, wobei die zusätzliche Umwandlungsschicht (20G) seitlich von einer Seitenfläche (24G) begrenzt wird, die zusätzliche Umwandlungsschicht zumindest einen zusätzlichen planaren Quantentopf (21G) umfasst, der so konfiguriert ist, dass er die dritte Strahlung emittiert, wobei ein zusätzliches Beugungsgitter (30G), das so konfiguriert ist, dass es mindestens einen Teil der dritten Strahlung aus der zusätzlichen Umwandlungsschicht (20G) extrahiert, auf eine Oberseite (25G) der zusätzlichen Umwandlungsschicht geätzt ist, und

o einen zusätzlichen seitlichen Reflektor (40G) mit einer reflektierenden Oberfläche (41G), von der sich zumindest ein Teil quer zu der zusätzlichen Umwandlungsschicht (20G) erstreckt und der Seitenfläche (24G) der zusätzlichen Umwandlungsschicht zugewandt ist.

10. Pixel (100) nach dem vorhergehenden Anspruch, **dadurch gekennzeichnet, dass** es eine weitere lichtemittierende optoelektronische Vorrichtung (1B) umfasst, die eine weitere lichtemittierende Diode (10B) enthält, die so konfiguriert ist, dass sie die erste Strahlung emittiert und die:

- entweder keine Umwandlungsschicht umfasst,
- oder mit einer zusätzlichen Umwandlungsschicht versehen ist, die so konfiguriert ist, dass sie zumindest einen Teil der ersten Strahlung in eine vierte Strahlung umwandelt, die sich von der zweiten und der dritten Strahlung unterscheidet.

11. Anzeigegerät, **dadurch gekennzeichnet, dass** es eine Matrix von Pixeln (100) nach Anspruch 9 oder 10 umfasst.

12. Verfahren zur Herstellung einer lichtemittierenden optoelektronischen Vorrichtung (1G, 1R; 1R'), das die folgenden Schritte umfasst:

- (S10) Herstellen einer lichtemittierenden Diode (10G, 10R), die so konfiguriert ist, dass sie eine erste Strahlung aussendet,
- (S2, S3) Herstellen einer Umwandlungsschicht (20G, 20R; 20R'), die sich über der lichtemittierenden Diode (10G, 10R) erstreckt und so konfiguriert ist, dass sie zumindest einen Teil der ersten Strahlung durch Photolumineszenz in eine zweite Strahlung umwandelt, wobei die Umwandlungsschicht seitlich durch eine Seitenfläche (24G, 24R) begrenzt ist,
- wobei der Schritt (S2, S3) des Herstellens der Umwandlungsschicht (20G, 20R; 20R') einen Schritt (S20, S30) des Herstellens eines planaren Quantentopfes (21G, 21R) umfasst, der so konfiguriert ist, dass er die zweite Strahlung emittiert, wobei das Verfahren ferner die folgenden Schritte umfasst:

o (S25, S35) Ätzen eines Beugungsgitters (30G, 30R) auf einer Oberseite (25G, 25R) der Umwandlungsschicht, wobei das Beugungsgitter so konfiguriert ist, dass es zumindest einen Teil der zweiten Strahlung aus der Umwandlungsschicht (20G, 20R; 20R') extrahiert, und

o (S4) Herstellen eines seitlichen Reflektors (40G, 40R) mit einer reflektierenden Oberfläche (41G, 41R), die sich quer zu der Umwandlungsschicht (20G, 20R; 20R') erstreckt und zumindest einem Teil der Seitenfläche (24G, 24R) der Umwandlungsschicht gegenüberliegt, wobei die reflektierende Oberfläche (41R, 41G) des Reflektors und die Seitenfläche (24R, 24G) der Umwandlungsschicht (20R, 20R') durch ein Material (50) mit einem optischen Index $n_2$ voneinander getrennt sind, und wobei ein Abstand ($d_R$, $d_G$), der die reflektierende Oberfläche (41R, 41G) des Reflektors von der Seitenfläche (24R, 24G) der Konversionsschicht trennt, zwischen $\lambda/(n_2 \times 40)$ und $\lambda/(n_2 \times 2)$ liegt, wobei $\lambda$ die mittlere Wellenlänge der zweiten Strahlung ist.

13. Verfahren nach dem vorhergehenden Anspruch, **dadurch gekennzeichnet, dass** die lichtemittierende Diode (10G, 10R) auf einem ersten Substrat (81) hergestellt wird, wobei das Verfahren ferner eine Verkapselung der lichtemittierenden Diode und eine Planarisierung (S11) einer Kontaktfläche (211, 212), die sich über der lichtemittierenden Diode befindet, umfasst, und bei dem der Schritt (S2, S3) zum Herstellen der Umwandlungsschicht (20G, 20R; 20R') die folgenden Schritte umfasst:

- (S20, S30) Herstellen auf einem zweiten Substrat (300, 400) eines Stapels, der den planaren Quantentopf (21G, 21R) umfasst,
- (S22, S32) Platzieren des Stapels auf der Kontaktfläche (211, 212) in Kontakt mit der Kontaktfläche, und Befestigen des Stapels an der Kontaktfläche (211, 212), und
- (S22, S32) Entfernen des zweiten Substrats (300, 400).

14. Verfahren zur Herstellung eines Pixels (100), das die folgenden Schritte umfasst:

- (S10) Herstellen einer ersten, zweiten und dritten lichtemittierenden Diode (10B, 10R, 10G), die jeweils so konfiguriert sind, dass sie eine erste Strahlung emittieren,
- (S2) Herstellen einer Umwandlungsschicht (20G), die sich über der dritten lichtemittierenden Diode (10G) erstreckt und so konfiguriert ist, dass sie zumindest einen Teil der ersten Strahlung durch Photolumineszenz in eine dritte Strahlung umwandelt, wobei die Umwandlungsschicht (20G) seitlich durch eine Seitenfläche (24G) begrenzt ist, wobei der Schritt des Herstellens Folgendes umfasst:

o einen Schritt (S20) des Herstellens mindestens eines planaren Quantentopfes (21G), der so konfiguriert ist, dass er die dritte Strahlung emittiert, und
o einen Schritt (S25) des Ätzens eines Beugungsgitters (30G) auf einer Oberseite (25G) der Umwandlungsschicht (20G), wobei das Beugungsgitter so konfiguriert ist, dass es zumindest einen Teil der dritten Strahlung aus der Umwandlungsschicht extrahiert,

- (S3) Herstellen einer Umwandlungsschicht (20R), die sich über der zweiten lichtemittierenden Diode (1R) erstreckt und so konfiguriert ist, dass sie zumindest einen Teil der ersten Strahlung durch Photolumineszenz in eine zweite Strahlung umwandelt, wobei die Umwandlungsschicht (20R) seitlich durch eine Seitenfläche (24R) begrenzt ist, wobei der Schritt des Herstellens Folgendes umfasst:

o einen Schritt (S30) des Herstellens mindestens eines planaren Quantentopfes (21R), der so konfiguriert ist, dass er die zweite Strahlung emittiert, und
o einen Schritt (S35) des Ätzens eines Beugungsgitters (30R) auf einer Oberseite (25R) der Umwandlungsschicht (20R), wobei das Beugungsgitter so konfiguriert ist, dass es zumindest einen Teil der zweiten Strahlung aus der Umwandlungsschicht (20R) extrahiert,

- (S4) Herstellen für jede Umwandlungsschicht (20R, 20G) eines seitlichen Reflektors (40R, 40G) mit einer reflektierenden Oberfläche (41R, 41G), die sich quer zu der betreffenden Umwandlungsschicht (20R, 20G) erstreckt und zumindest einem Teil der Seitenfläche (24R, 24G) dieser Umwandlungsschicht gegenüberliegt, wobei die reflektierende Oberfläche (41R, 41G) des Reflektors und die Seitenfläche (24R, 24G) der betreffenden Umwandlungsschicht (20R; 20R; 20G) durch ein Material (50) mit einem optischen Index $n_2$ voneinander getrennt sind, und wobei ein Abstand ($d_R$, $d_G$), der die reflektierende Oberfläche (41R, 41G) des Reflektors von der Seitenfläche (24R, 24G) der Konversionsschicht trennt, zwischen $\lambda/(n_2 \times 40)$ und $\lambda/(n_2 \times 2)$ liegt, wobei $\lambda$ die mittlere Wellenlänge der zweiten Strahlung ist.

## Claims

1. Optoelectronic light emitting device (1R; 1R', 1G) comprising:

- a light emitting diode (10R, 10G) configured to emit a first radiation, and
- a conversion layer (20R; 20R', 20G) which extends above the light emitting diode (10R, 10G) and which is configured to convert a part at least of the first radiation into a second radiation, by photoluminescence, the conversion layer being delimited laterally by a lateral surface (24R, 24G), the conversion layer (20R; 20R', 20G) comprising at least one planar quantum well (21R, 21G) configured to emit the second radiation,
- a diffraction grating (30R; 30R', 30G), configured to extract a part at least of the second radiation from the conversion layer, the diffraction grating being etched on an upper face (25R, 25G) of the conversion layer,
- the device further comprising a lateral reflector (40R, 40G) having a reflective surface (41R, 41G) which extends transversally with respect to the conversion layer (20R; 20R', 20G), facing a part at least of the lateral surface (24R, 24G) of the conversion layer, the reflective surface (41R, 41G) of the reflector and the lateral surface (24R, 24G) of the conversion layer (20R; 20R', 20G) being separated from each other by a material (50) having an optical index $n_2$,

**characterized in that** a distance ($d_R$, $d_G$) separating the reflective surface (41R, 41G) of the reflector from the lateral surface (24R, 24G) of the conversion layer is comprised between $\lambda/(n_2 \times 40)$ and $\lambda/(n_2 \times 2)$ where $\lambda$ is the average wavelength of the second radiation.

2. Device (1R; 1R', 1G) according to the preceding claim, wherein the reflective surface (41R, 41G) of the reflector extends around the conversion layer (20R; 20R', 20G), over the major part of the perimeter of the conversion layer.

3. Device (1R; 1R', 1G) according to any one of the preceding claims, wherein the reflective surface (41R, 41G) of the reflector comprises at least a first reflective face (46R, 46G) and a second reflective face (47R, 47G), each reflective face (46R, 47R, 46G, 47G) extending transversally with respect to the conversion layer (20R; 20R', 20G), facing a part (26R, 27R, 26G, 27G) of the lateral surface (24R, 24G) of the conversion layer, the second reflective face (47R, 47G) being situated opposite the first reflective face (46R, 46G) with respect to the conversion layer (20R; 20R', 20G), the first and second reflective faces being substantially parallel with each other.

4. Device (1R; 1 R', 1G) according to any one of the preceding claims, wherein the reflector (40R, 40G) is formed, at least superficially, of a metal.

5. Device (1R; 1 R', 1G) according to any one of the preceding claims wherein the upper face (25R, 25G) of the conversion layer (20R; 20R', 20G) extends onto an area less than 1000 microns square, or even less than 100 microns square.

6. Device (1R; 1 R', 1G) according to any one of the preceding claims wherein the light emitting diode (10R, 10G) comprises an active layer (15) from where is emitted the first radiation, the device (1R; 1R', 1G) further comprising a lateral confinement system which includes said lateral reflector (40R, 40G), which extends axially from the active layer (15) to the conversion layer (20R; 20R', 20G) and which is configured to confine the first radiation laterally.

7. Device (1R') according to any one of the preceding claims, comprising a first multilayer reflective filter (35R) which extends between the light emitting diode (10R) and the planar quantum well (21R) and which is at least partially reflective for the second radiation.

8. Device (1R') according to any one of the preceding claims, comprising a second multilayer reflective filter (36R) which extends above the planar quantum well (21R) and which is at least partially reflective for the first radiation.

9. Pixel (100) comprising:

   - an optoelectronic device (1R; 1 R') according to any one of the preceding claims, and
   - an additional optoelectronic light emitting device (1G) comprising:

     o an additional light emitting diode (10G), configured to emit said first radiation,
     o an additional conversion layer (20G) which extends above the additional light emitting diode (10G) and which is configured to convert a part at least of the first radiation into a third radiation, by photoluminescence, the additional conversion layer (20G) being delimited laterally by a lateral surface (24G), the additional conversion layer comprising at least one additional planar quantum well (21G) configured to emit the third radiation, an additional diffraction grating (30G), configured to extract a part at least of the third radiation from the additional conversion layer (20G), the additional diffraction grating being etched on an upper face (25G) of the additional conversion layer, and
     ∘ an additional lateral reflector (40G) having a reflective surface (41G) of which a part at least extends transversally with respect to the additional conversion layer (20G), facing the lateral surface (24G) of the additional conversion layer.

10. Pixel (100) according to the preceding claim further comprising another optoelectronic light emitting device (1B) which comprises another light emitting diode (10B) configured to emit said first radiation and which is:

    - either with no conversion layer,
    - or provided with an additional conversion layer, configured to convert a part at least of the first radiation into a fourth radiation different from the second and third radiations.

11. Display comprising a matrix of pixels (100) according to claim 9 or 10.

**12.** Method for manufacturing an optoelectronic light emitting device (1G, 1R; 1R'), comprising the following steps:

- (S10) producing a light emitting diode (10G, 10R) configured to emit a first radiation,
- (S2, S3) producing a conversion layer (20G, 20R; 20R'), which extends above the light emitting diode (10G, 10R) and which is configured to convert a part at least of the first radiation into a second radiation, by photoluminescence, the conversion layer being delimited laterally by a lateral surface (24G, 24R),
- the step (S2, S3) of producing the conversion layer (20G, 20R; 20R') comprising a step (S20, S30) of producing a planar quantum well (21G, 21R) configured to emit the second radiation, the method further comprising the following steps:

o (S25, S35) etching a diffraction grating (30G, 30R) on an upper face (25G, 25R) of the conversion layer, the diffraction grating being configured to extract a part at least of the second radiation from the conversion layer (20G, 20R; 20R'), and
o (S4) producing a lateral reflector (40G, 40R) having a reflective surface (41G, 41R) which extends transversally with respect to the conversion layer (20G, 20R; 20R'), facing a part at least of the lateral surface (24G, 24R) of the conversion layer, the reflective surface (41R, 41G) of the reflector and the lateral surface (24R, 24G) of the conversion layer (20R; 20R', 20G) being separated from each other by a material (50) having an optical index $n_2$, and wherein a distance ($d_R$, $d_G$) separating the reflective surface (41R, 41G) of the reflector from the lateral surface (24R, 24G) of the conversion layer is comprised between $\lambda/(n_2 \times 40)$ and $\lambda/(n_2 \times 2)$ where $\lambda$ is the average wavelength of the second radiation.

**13.** Method according to the preceding claim, wherein the light emitting diode (10G, 10R) is produced on a first substrate (81), the method further comprising an encapsulation of the light emitting diode and a planarization (S11) of a contact surface (211, 212) situated above the light emitting diode, and wherein the step (S2, S3) of producing the conversion layer (20G, 20R; 20R') comprises the following steps:

- (S20, S30) on a second substrate (300, 400), producing a stack comprising said planar quantum well (21G, 21R),
- (S22, S32) placing said stack on said contact surface (211, 212), in contact with said contact surface, and fixing said stack onto the contact surface (211, 212), and
- (S22, S32) removing the second substrate (300, 400).

**14.** Method for manufacturing a pixel (100), comprising the following steps:

- (S10) producing a first, second and third light emitting diodes (10B, 10R, 10G), each configured to emit a first radiation,
- (S2) producing a conversion layer (20G), which extends above the third light emitting diode (10G) and which is configured to convert a part at least of the first radiation into a third radiation, by photoluminescence, the conversion layer (20G) being delimited laterally by a lateral surface (24G), said production step comprising:

o a step (S20) of producing at least one planar quantum well (21G) configured to emit the third radiation, and
o a step (S25) of etching a diffraction grating (30G) on an upper face (25G) of the conversion layer (20G), the diffraction grating being configured to extract a part at least of the third radiation from the conversion layer,

- (S3) producing a conversion layer (20R), which extends above the second light emitting diode (1R) and which is configured to convert a part at least of the first radiation into a second radiation, by photoluminescence, the conversion layer (20R) being delimited laterally by a lateral surface (24R), said production step comprising:

o a step (S30) of producing at least one planar quantum well (21R) configured to emit the second radiation, and
o a step (S35) of etching a diffraction grating (30R) on an upper face (25R) of the conversion layer (20R), the diffraction grating being configured to extract a part at least of the second radiation from the conversion layer (20R),

- (S4) for each conversion layer (20R, 20G), producing a lateral reflector (40R, 40G) having a reflective surface (41R, 41G) which extends transversally with respect to the conversion layer (20R, 20G) considered, facing a part at least of the lateral surface (24R, 24G) of this conversion layer, the reflective surface (41R, 41G) of the reflector and the lateral surface (24R, 24G) of the conversion layer (20R; 20R', 20G) considered being separated from each other by a material (50) having an optical index $n_2$, and wherein a distance ($d_R$, $d_G$) separating the reflective surface (41R, 41G) of the reflector from the lateral surface (24R, 24G) of the conversion layer considered is comprised between $\lambda/(n_2 \times 40)$ and $\lambda/(n_2 \times 2)$ where $\lambda$ is the average wavelength of the second radiation, or, respectively of the third radiation.

# Fig. 1

# Fig. 2

# Fig. 3

# Fig. 4

**Fig. 5**

**Fig. 6**

# Fig. 7

# Fig. 8

S20

S22

S23

S21

S2

S25

S24

S26

S27

S30

S32

S33

S31

S3

S35

S34

S36

S37

Fig. 9

Fig. 10

Fig. 11

**Fig. 12**

EP 3 929 634 B1

EP 3 929 634 B1

**Fig. 13**

## Fig. 14

EP 3 929 634 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **GUAN-SYUN CHEN et al.** Monolithic red/green/blue micro-LEDs with HBR and DBR structures. *IEEE Photonics Technology Letters,* 01 Février 2018, vol. 30 (3